# EUROPÄISCHE PATENTSCHRIFT

(11) **EP 4 404 421 B1**
(45) Veröffentlichungstag und Bekanntmachung des Hinweises auf die Patenterteilung: **30.07.2025**
(21) Anmeldenummer: 23151989.3
(22) Anmeldetag: 17.01.2023
(51) Int. Cl.: H02J 7/00, G01R 31/392

(54) **SYSTEM MIT EINEM AKKU UND VERFAHREN ZUM BETREIBEN EINES SYSTEMS MIT EINEM AKKU**
SYSTEM WITH A RECHARGEABLE BATTERY AND METHOD FOR OPERATING A SYSTEM WITH A RECHARGEABLE BATTERY
SYSTÈME COMPRENANT UNE BATTERIE RECHARGEABLE ET PROCÉDÉ DE FONCTIONNEMENT D'UN SYSTÈME COMPRENANT UNE BATTERIE RECHARGEABLE

(43) Veröffentlichungstag der Anmeldung: 24.07.2024
(73) Patentinhaber: Vorwerk & Co. Interholding GmbH, 42275 Wuppertal (DE)
(72) Erfinder: SAUERWALD, Dr. Andres, 46238 Bottrop (DE); BEZSONOV, Viktor, 40211 Düsseldorf (DE); ISENBERG, Gerhard, 50668 Köln (DE)
(74) Vertreter: Von Rohr Patentanwälte Partnerschaft mbB

(56) Entgegenhaltungen:
- DE-A1- 102017 009 448
- US-A1- 2019 033 385

## Beschreibung

Die vorliegende Erfindung betrifft ein Verfahren zum Betreiben eines Systems mit einem Akku sowie ein System mit einem Akku.

Es ist bekannt, dass Akkus, insbesondere Lithium-Ionen-Akkus, nicht mehr verwendet bzw. geladen werden dürfen, wenn sie eine Mindestruhespannung unterschritten haben, da es sonst zu einem Akkubrand kommen kann, insbesondere aufgrund interner Kurzschlüsse, verursacht beispielsweise durch Dendriten oder Lithium Plating.

Aus Sicherheitsgründen kann eine Schutzelektronik eingesetzt werden, die bei Erreichen oder Unterschreiten der Mindestruhespannung ein Laden des Akkus unterbindet, um eine Zerstörung des Akkus bzw. einen Akkubrand zu verhindern. Wenn ein Laden des Akkus durch die Schutzelektronik unterbunden wird, wird der Akku für einen Benutzer unbrauchbar und muss entsorgt werden.

Durch eine solche Schutzelektronik erfolgt jedoch eine Selbstentladung des Akkus, die zu einem Unterschreiten der vorgegebenen Mindestruhespannung führen kann. Ferner kann eine Selbstentladung des Akkus beispielsweise durch einen Ruhestromverbrauch eines an den Akku angeschlossenen Verbrauchers bzw. Geräts bedingt sein.

Der vorliegenden Erfindung liegt daher die Aufgabe zugrunde, das Risiko eines insbesondere durch Selbstentladung des Akkus verursachten Erreichens oder Unterschreitens einer vorgegebenen Mindestruhespannung eines Akkus und/oder einer Beschädigung oder Zerstörung eines Akkus zu verhindern oder zumindest zu reduzieren.

Die US 2019/0033385 A1 betrifft ein Verfahren zur Bestimmung eines Ladezustands, einer Selbstentladungsrate und einer vorhergesagten verbleibenden Zeit bis zum Erreichen eines vorbestimmten minimalen Ladezustands bei einer Batterie. Insbesondere wird eine verbleibende Zeit (tREMX) berechnet, bis die Batterie sich bis zu einem vorbestimmten minimalen Ladungszustand (SOCmin) unter Lager- oder Transitbedingungen selbst entlädt.

Die DE 10 2017 009 448 A1 betrifft ein Verfahren zum Ermitteln einer Selbstentladung einer Batterie, bei welchem eine Spannung wenigstens einer Batteriezelle der Batterie erfasst und beim Ermitteln der Selbstentladung der Batterie berücksichtigt wird. Basierend auf einem nichtlinearen zeitlichen Verlauf der Spannung wird eine für wenigstens einen Zeitpunkt in der Zukunft erwartete Selbstentladung der Batterie vorhergesagt. Ein minimal zulässiger Ladezustand, bis zu dem sich die Batterie entladen darf, wird durch einen Nutzer festgelegt.

Die der Erfindung zugrunde liegende Aufgabe wird gelöst durch ein Verfahren gemäß Anspruch 1 oder ein System mit einem Akku gemäß Anspruch 12. Vorteilhafte Weiterbildungen sind Gegenstand der Unteransprüche.

Die vorliegende Erfindung betrifft ein (vorzugsweise computerimplementiertes) Verfahren zum Betreiben eines Systems mit einem Akku, insbesondere Lithium-Ionen- Akku, wobei unter Berücksichtigung einer (systeminhärenten) Selbstentladung des Systems automatisch eine (maximale) Lagerungszeit des Akkus bestimmt wird, wobei die Lagerungszeit die bei Nichtbenutzung bzw. Lagerung des Akkus bis zum Erreichen oder Unterschreiten eines vorgegebenen Grenzwerts einer Ruhespannung des Akkus verbleibende Zeit ist. Hierdurch kann verhindert werden, dass eine vorgegebene Mindestruhespannung des Akkus unterschritten wird bzw. eine Tiefentladung des Akkus erfolgt, insbesondere indem ein Nutzer über die bestimmte Lagerungszeit und/oder ein erforderliches Laden des Akkus informiert wird. Es kann somit verhindert werden, dass der Akku beschädigt bzw. unbrauchbar wird.

Der Akku weist eine dem Akku, insbesondere bis zum Erreichen des vorgegebenen Grenzwerts, entnehmbare Ladungsmenge auf, die bei der Bestimmung der Lagerungszeit verwendet bzw. berücksichtigt wird.

Die dem Akku entnehmbare Ladungsmenge wird häufig auch als (entnehmbare) Kapazität des Akkus bezeichnet und beispielsweise in mAh ausgedrückt. Die dem Akku entnehmbare Ladungsmenge hängt insbesondere von dem Ladezustand des Akkus ab. Wenn der Akku vollgeladen ist, ist die dem Akku entnehmbare Ladungsmenge größer, als wenn der Akku teilweise entladen ist. Die dem Akku entnehmbare Ladungsmenge stellt vorzugsweise einen Parameter bzw. eine Rechengröße dar, auf deren Basis die Lagerungszeit bestimmt, insbesondere berechnet, wird, bzw. die in eine Formel zur Berechnung der Lagerungszeit eingeht.

Die Verwendung bzw. Berücksichtigung der dem Akku entnehmbaren Ladungsmenge ermöglicht insbesondere eine akkuspezifische und/oder präzise Bestimmung der Lagerungszeit.

Die dem Akku entnehmbare Ladungsmenge ist von einem Ladungsmengenindikator des Akkus abhängig.

Der Ladungsmengenindikator ist eine Größe, anhand derer die dem Akku entnehmbare Ladungsmenge bestimmt werden kann bzw. wird. Insbesondere ist der Ladungsmengenindikator eine direkt, insbesondere durch Messung an dem Akku, ermittelbare Größe. Bevorzugt ist der Ladungsmengenindikator ein Ladezustand oder eine Ruhespannung des Akkus.

Bei der Bestimmung der Lagerungszeit wird eine Ladungsmengenfunktion verwendet, die verschiedenen Werten des Ladungsmengenindikators jeweils eine verfügbare Ladungsmenge zuordnet. Die Ladungsmengenfunktion beschreibt also insbesondere den (funktionalen) Zusammenhang zwischen dem Ladungsmengenindikator bzw. dessen Werten und der zu den jeweiligen Werten des Ladungsmengenindikators korrespondierenden Ladungsmenge, die dem Akku entnehmbar ist.

Durch die Verwendung der Ladungsmengenfunktion kann auf einfache Weise auf Basis des Ladungsmengenindikators, also einer vorzugsweise leicht und/oder direkt am Akku zu bestimmenden bzw. zu messenden Größe, die entnehmbare Ladungsmenge bzw. deren Verlauf in Abhängigkeit von dem Ladungsmengenindikator bestimmt bzw. bei der Bestimmung der Lagerungszeit verwendet werden. Dies ist einer genauen, zuverlässigen und akkuspezifischen Bestimmung der Lagerungszeit zuträglich.

Ferner ist die zu einem bestimmten Wert des Ladungsmengenindikators korrespondierende bzw. die einem bestimmten Wert des Ladungsmengenindikators zugeordnete Ladungsmenge von einem Alterungszustand des Akkus abhängig.

Der Alterungszustand ist insbesondere ein Maß für die kalendarische und/oder zyklische Alterung des Akkus, also einen Alterungsprozess des Akkus, durch den mit zunehmender Zeit und/oder einer zunehmenden Anzahl an Ladezyklen die Leistungsfähigkeit des Akkus abnimmt, was sich insbesondere in einer Abnahme der maximalen Kapazität bzw. der einem vollgeladenen Akku entnehmbaren Ladungsmenge und/oder einer Zunahme des Innenwiderstands äußert.

Erfindungsgemäß ist daher verschiedenen Alterungszuständen des Akkus jeweils eine Ladungsmengenfunktion zugeordnet. Bei der Bestimmung der Lagerungszeit wird erfindungsgemäß die dem jeweiligen Alterungszustand des Akkus zugeordnete Ladungsmengenfunktion verwendet. Durch die Berücksichtigung des Alterungszustands bzw. die Verwendung einer solchen Alterungszustands-spezifischen Ladungsmengenfunktion kann die Genauigkeit bei der Bestimmung der Lagerungszeit weiter verbessert werden.

Der Akku weist vorzugsweise einen Ruhestromverbrauch auf, der bei der Bestimmung der Lagerungszeit verwendet bzw. berücksichtigt wird. Der Ruhestromverbrauch ist insbesondere durch die Selbstentladung des Akkus bedingt, zumindest teilweise. Es ist jedoch auch möglich, dass in den Ruhestromverbrauch nicht nur der Ruhestrom durch die Selbstentladung des Akkus, sondern alternativ oder zusätzlich der Ruhestrom weiterer an den Akku angeschlossener Verbraucher, beispielweise der Ruhestromverbrauch im Standby-Modus eines mit dem Akku betriebenen Geräts, einfließt bzw. berücksichtigt ist.

Der Ruhestromverbrauch des Akkus stellt vorzugsweise einen Parameter bzw. eine Rechengröße dar, auf deren Basis die Lagerungszeit bestimmt, insbesondere berechnet, wird, bzw. die in eine Formel zur Berechnung der Lagerungszeit eingeht.

Insbesondere wird die Lagerungszeit grundsätzlich als Quotient zwischen der dem Akku entnehmbaren Ladungsmenge und dem Ruhestromverbrauch des Akkus bei Lagerung berechnet.

Mittels des Ruhestromverbrauchs kann die Lagerungszeit vorzugsweise präzise und zuverlässig bestimmt werden.

Der Ruhestromverbrauch des Akkus ist insbesondere von dem Ladungsmengenindikator des Akkus bzw. dessen Wert abhängig. Daher wird bei der Bestimmung der Lagerungszeit vorzugsweise eine Ruhestromfunktion verwendet wird, die verschiedenen Werten des Ladungsmengenindikators jeweils einen Ruhestromverbrauch zuordnet. Die Ruhestromfunktion beschreibt also insbesondere den (funktionalen) Zusammenhang zwischen dem Ladungsmengenindikator bzw. dessen Werten und dem zu den jeweiligen Werten des Ladungsmengenindikators korrespondierenden Ruhestromverbrauch des Akkus.

Durch die Verwendung der Ruhestromfunktion kann auf einfache Weise auf Basis des Ladungsmengenindikators, also einer vorzugsweise leicht und/oder direkt am Akku zu bestimmenden bzw. zu messenden Größe, der Ruhestromverbrauch des Akkus bzw. dessen Verlauf in Abhängigkeit von dem Ladungsmengenindikator bestimmt bzw. bei der Bestimmung der Lagerungszeit verwendet werden. Dies ist einer genauen, zuverlässigen und akkuspezifischen Bestimmung der Lagerungszeit zuträglich.

Ferner ist der zu einem bestimmten Wert des Ladungsmengenindikators korrespondierende bzw. die einem bestimmten Wert des Ladungsmengenindikators zugeordnete Ruhestromverbrauch insbesondere von der Umgebungstemperatur des Akkus abhängig. Beispielsweise ist bei einem Akku mit einer bestimmten Ruhespannung der Ruhestromverbrauch höher je höher die Umgebungstemperatur ist.

Vorzugsweise ist daher verschiedenen Umgebungstemperaturen des Akkus jeweils eine Ruhestromfunktion zugeordnet.

Bei der Bestimmung der Lagerungszeit wird vorzugsweise die der jeweiligen Umgebungstemperatur des Akkus zugeordnete Ruhestromfunktion verwendet. Die Umgebungstemperatur des Akkus kann hierbei gemessen werden, beispielsweise durch einen Temperatursensor des Akkus bzw. System, oder durch einen Nutzer als Parameter vorgegeben sein/werden. Die Berücksichtigung der Umgebungstemperatur bzw. der Abhängigkeit des Ruhestromverbrauchs von der Umgebungstemperatur ermöglicht eine weitere Verbesserung der Genauigkeit bei der Bestimmung der Lagerungszeit.

Es ist besonders bevorzugt, dass die Bestimmung der Lagerungszeit auf Basis der dem Akku (insbesondere zu dem Zeitpunkt, zu dem die Lagerungszeit bestimmt wird) entnehmbaren Ladungsmenge, der Ladungsmengenfunktion und der Ruhestromfunktion erfolgt. Insbesondere wird die Lagerungszeit dabei iterativ, numerisch, durch Integration und/oder durch Mittelung, insbesondere der Ruhestromfunktion und/oder Ladungsmengenfunktion, bestimmt bzw. berechnet, besonders bevorzugt als Quotient aus entnehmbarer Ladungsmenge und (durchschnittlichem oder mittlerem) Ruhestromverbrauch. Dabei ist die dem Akku entnehmbare Ladungsmenge vorzugsweise eine feste Zahl, die den Ausgangspunkt der Berechnung bildet und sich während der Berechnung nicht ändert. Der Ruhestromverbrauch hingegen hängt vorzugsweise von der Ruhespannung ab, wobei sich durch den Ruhestromverbrauch in einem bestimmten Zeitintervall die entnehmbare Ladungsmenge und damit wiederum die Ruhespannung am Ende des Zeitintervalls verringert. Dies wird vorzugsweise berücksichtigt, sodass eine möglichst präzise Bestimmung der Lagerungszeit erfolgt.

Vorzugsweise wird/werden bei der Bestimmung der Lagerungszeit ein Ladungsmengenindikator, ein Alterungszustand, ein Akkutyp und/oder eine eineindeutige Identifikationsnummer des Akkus verwendet bzw. berücksichtigt. Insbesondere wird/werden die genannten Größen zur Bestimmung der Lagerungszeit abgerufen, beispielsweise von dem Akku, und erfolgt anschließend die Bestimmung der Lagerzeit ausgehend von den abgerufenen Größen.

Der Ladungsmengenindikator ist vorzugsweise der Ladezustand oder die Ruhespannung des Akkus.

Der Ladungsmengenindikator und vorzugsweise der Alterungszustand wird/werden insbesondere zur Bestimmung der dem Akku entnehmbaren Ladungsmenge verwendet. Der Alterungszustand, der Akkutyp und/oder die eineindeutige Identifikationsnummer werden insbesondere zur Auswahl der dem Akku zugehörigen Ladungsmengenfunktion und/oder Ruhestromfunktion verwendet. Das genannte Vorgehen ermöglicht insbesondere eine genaue und akkuspezifische Bestimmung der Lagerungszeit.

Das System weist vorzugsweise eine mit dem Akku betriebene Schutzelektronik auf, die dazu ausgebildet ist, den Akku gegen eine weitere Nutzung und/oder ein Laden zu sperren, wenn eine vorgegebene Mindestruhespannung des Akkus erreicht oder unterschritten wird, wobei die Selbstentladung zumindest teilweise durch den Betrieb der Schutzelektronik bei Lagerung des Akkus erfolgt. Hierdurch kann eine Tiefentladung bzw. eine Beschädigung oder Zerstörung des Akkus verhindert werden.

Vorzugsweise weist das System ein an den Akku angeschlossenes Gerät mit einem Ruhestromverbrauch auf, wobei durch den Ruhestromverbrauch des Geräts eine Selbstentladung des Akkus bei Lagerung erfolgt und die Selbstentladung durch den Ruhestromverbrauch des Geräts bei der Bestimmung der Lagerungszeit des Akkus berücksichtigt wird. Dies ist einer genauen, zuverlässigen und akkuspezifischen Bestimmung der Lagerungszeit zuträglich.

Vorzugsweise erfolgt die Bestimmung der Lagerungszeit automatisch, wenn bzw. bevor das System bzw. der Akku deaktiviert, insbesondere ausgeschaltet oder in einen Standby-Modus versetzt, wird. Hierdurch ist nach jeder Verwendung des Systems bzw. des Akkus die aktuelle Lagerungszeit bekannt.

Es ist bevorzugt, dass nach der Bestimmung der Lagerungszeit und/oder vor Erreichen oder Unterschreiten des Grenzwerts automatisch eine Mitteilung über den Ladezustand, die bestimmte Lagerungszeit, ein erforderliches Laden des Akkus und/oder ein Blockieren eines Ladens des Akkus ausgegeben wird, insbesondere über eine Benutzerschnittstelle. Hierdurch wird einem Benutzer ein rechtzeitiges Laden des Akkus ermöglicht, wodurch eine Beschädigung oder Zerstörung des Ackus verhindert werden kann.

Vorzugsweise ist der vorgegebene Grenzwert einer der folgenden Grenzwerte und/oder wird bezüglich mehrerer oder aller der folgenden Grenzwerte die jeweilige Lagerungszeit bestimmt bzw. berechnet:
a) (erster) Grenzwert, bei dessen Erreichen oder Unterschreiten ein Laden des Akkus automatisch blockiert wird;
b) (zweiter) Grenzwert, bei dessen Erreichen oder Unterschreiten eine Lagerung des Akkus ohne Laden des Akkus - insbesondere innerhalb einer vorgegebenen Zeit - nicht mehr möglich ist;
c) (dritter) Grenzwert, bei dessen Erreichen oder Unterschreiten keine Nutzung des Akkus ohne vorheriges Laden möglich ist.

Gemäß einem weiteren, auch unabhängig realisierbaren Aspekt betrifft die vorliegende Erfindung ein System mit einem Akku, insbesondere wobei der Akku zum Betreiben eines Haushaltsgeräts ausgebildet ist. Das System weist vorzugsweise zusätzlich zu dem Akku ein mit dem Akku betreibbares Gerät, insbesondere Haushaltsgerät, ein insbesondere mit dem Akku und/oder dem Gerät datentechnisch verbundenes oder verbindbares Kommunikationsgerät, und/oder eine insbesondere mit dem Kommunikationsgerät, dem Gerät und/oder dem Akku datentechnisch verbundene oder verbindbare Datenbank auf. Das System ist vorzugsweise zum Durchführen eines hierin beschriebenen Verfahrens ausgebildet. Insbesondere werden durch das System entsprechende Vorteile des Verfahrens erreicht.

Die vorgenannten Aspekte, Merkmale und Verfahrensschritte der vorliegenden Erfindung sowie die sich aus den Ansprüchen und der nachfolgenden Beschreibung ergebenen Aspekte, Merkmale und Verfahrensschritte der vorliegenden Erfindung können grundsätzlich unabhängig voneinander, aber auch in beliebiger Kombination bzw. Reihenfolge realisiert werden.

Weitere Aspekte, Vorteile, Merkmale und Eigenschaften der vorliegenden Erfindung ergeben sich aus den Ansprüchen und der nachfolgenden Beschreibung einer bevorzugten Ausführungsform anhand der Figuren. Es zeigt:
- Fig. 1: eine schematische Darstellung eines erfindungsgemäßen Systems;
- Fig. 2A: eine schematische Darstellung verschiedener Ladungsmengenfunktionen;
- Fig. 2B: eine weitere schematische Darstellung verschiedener Ladungsmengenfunktionen;
- Fig. 3: eine schematische Darstellung einer Ruhespannung eines Akkus in Abhängigkeit von einer dem Akku entnommenen Ladungsmenge;
- Fig. 4: eine schematische Darstellung einer Ruhestromfunktion; und
- Fig. 5: eine schematische Darstellung eines Ruhestromverbrauchs eines Ackus in Abhängigkeit von der Ruhespannung des Akkus.

In den Figuren werden für gleiche, gleichartige oder ähnliche Bauteile und Komponenten dieselben Bezugszeichen verwendet, wobei entsprechende oder vergleichbare Eigenschaften oder Vorteile erreicht werden, auch wenn von einer wiederholten Beschreibung abgesehen wird.

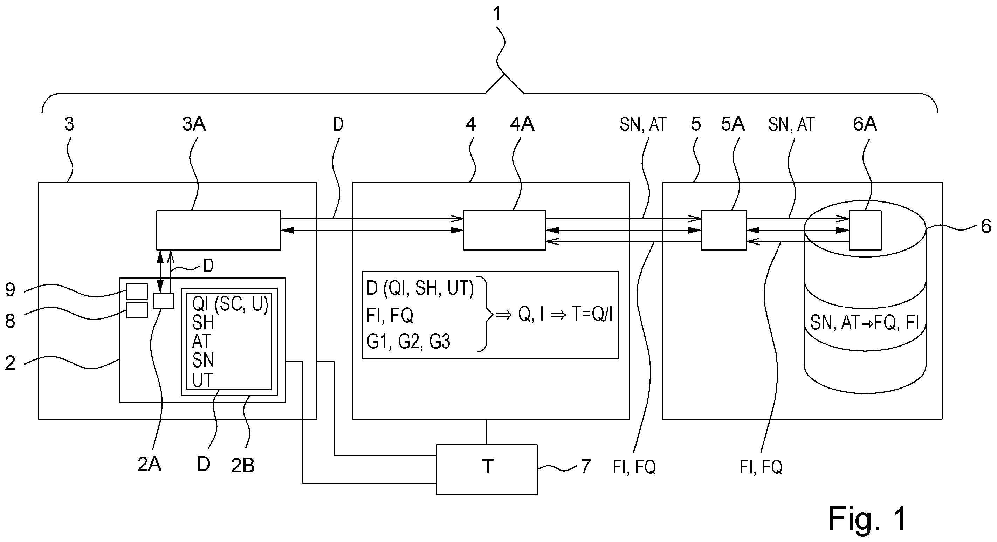

In Fig. 1 ist ein erfindungsgemäßes System 1 schematisch dargestellt. Das System 1 weist einen Akku 2 auf. Optional, jedoch bevorzugt, weist das System 1 zusätzlich zu dem Akku 2 ein Gerät 3, ein Kommunikationsgerät 4, eine Datenverarbeitungseinrichtung 5 und/oder eine Datenbank 6 auf.

Der Akku 2 ist vorzugsweise ein Lithium-Ionen-Akku. Vorzugsweise weist der Akku 2 mehrere, insbesondere parallel und/oder seriell verschaltete, Zellen auf. Die Nennkapazität bzw. maximale Kapazität oder maximal entnehmbare Ladungsmenge Q des Akkus 2 beträgt vorzugsweise mehr als 1.000 mAh und/oder weniger als 10.000 mAh. Die Ruhespannung U des Akkus 2 beträgt vorzugsweise mehr als 5 V und/oder weniger als 50 V. Das Gewicht des Akkus 2 beträgt vorzugsweise weniger als 3 kg.

Vorzugsweise weist der Akku 2 einen Datenspeicher 2B auf. Insbesondere sind in dem Datenspeicher 2B (akkuspezifische) Daten D speicherbar bzw. gespeichert. Dies wird später noch genauer erläutert.

Der Akku 2 ist vorzugsweise dem Gerät 3 zugeordnet und/oder zum Betreiben des Geräts 3 ausgebildet. Insbesondere stellt der Akku 2 die zum Betreiben des Geräts 3 erforderliche Energie bereit.

Das Gerät 3 weist vorzugsweise den Akku 2 auf. Der Akku 2 ist vorzugsweise aus dem Gerät 3 entnehmbar.

Das Gerät 3 ist vorzugsweise ein Haushaltsgerät, insbesondere ein akkubetriebenes (Boden-)Reinigungsgerät, besonders bevorzugt ein Saugroboter, Staubsauger, Wischsauger, Fensterreiniger oder dergleichen. Grundsätzlich kann sich bei dem Gerät 3 jedoch um ein beliebiges akkubetriebenes Gerät bzw. Haushaltsgerät handeln.

Das Kommunikationsgerät 4 ist vorzugsweise ein (mobiles) Endgerät, insbesondere ein Mobiltelefon, ein Smartphone, ein Laptop, ein Tablet-Computer, ein PC oder dergleichen, insbesondere eines Nutzers bzw. Eigentümers des Geräts 3.

Die Datenverarbeitungseinrichtung 5 ist vorzugsweise eine Cloud, ein Server, ein Rechenzentrum oder dergleichen, insbesondere des Herstellers des Geräts 3. Vorzugsweise weist die Datenverarbeitungseinrichtung 5 die Datenbank 6 auf.

Der Akku 2 ist vorzugsweise mit dem Gerät 3, dem Kommunikationsgerät 4, der Datenverarbeitungseinrichtung 5 und/oder der Datenbank 6 datentechnisch verbunden bzw. verbindbar. Hierzu weist der Akku 2 vorzugsweise eine Kommunikationsschnittstelle 2A auf. Insbesondere ist der Akku 2 zur (Daten-)Kommunikation mit dem Gerät 3, dem Kommunikationsgerät 4, der Datenverarbeitungseinrichtung 5 und/oder der Datenbank 6 ausgebildet, insbesondere mittels der Kommunikationsschnittstelle 2A.

Das Gerät 3 ist vorzugsweise mit dem Akku 2, dem Kommunikationsgerät 4, der Datenverarbeitungseinrichtung 5 und/oder der Datenbank 6 datentechnisch verbunden bzw. verbindbar. Hierzu weist das Gerät 3 vorzugsweise eine Kommunikationsschnittstelle 3A auf. Insbesondere ist das Gerät 3 zur (Daten-)Kommunikation mit dem Akku 2, dem Kommunikationsgerät 4 der Datenverarbeitungseinrichtung 5, und/oder der Datenbank 6 ausgebildet, insbesondere mittels der Kommunikationsschnittstelle 3A.

Das Kommunikationsgerät 4 ist vorzugsweise mit dem Akku 2, dem Gerät 3, der Datenverarbeitungseinrichtung 5 und/oder der Datenbank 6 datentechnisch verbunden bzw. verbindbar. Hierzu weist das Kommunikationsgerät 4 vorzugsweise eine Kommunikationsschnittstelle 4A auf. Insbesondere ist das Kommunikationsgerät 4 zur (Daten-)Kommunikation mit dem Akku 2, dem Gerät 3, der Datenverarbeitungseinrichtung 5 und/oder der Datenbank 6 ausgebildet, insbesondere mittels der Kommunikationsschnittstelle 4A.

Das Kommunikationsgerät 4 weist vorzugsweise eine App zur Bedienung und/oder Steuerung des Geräts 3 auf. Das Kommunikationsgerät 4 bzw. die App ist vorzugsweise mit dem Gerät 3 koppelbar, insbesondere über die Kommunikationsschnittstellen 3A, 4A des Geräts 3 und des Kommunikationsgeräts 4. Vorzugsweise sind mittels der App Informationen über das Gerät 3 und/oder den Akku 2 abrufbar und/oder sind mit der App Einstellungen zum Betrieb des Geräts 3 vornehmbar bzw. veränderbar.

Die Datenverarbeitungseinrichtung 5 ist vorzugsweise mit dem Akku 2, dem Gerät 3, dem Kommunikationsgerät 4 und/oder der Datenbank 6 datentechnisch verbunden bzw. verbindbar. Hierzu weist die Datenverarbeitungseinrichtung 5 vorzugsweise eine Kommunikationsschnittstelle 5A auf. Insbesondere ist die Datenverarbeitungseinrichtung 5 zur (Daten-)Kommunikation mit dem Akku 2, dem Gerät 3, dem Kommunikationsgerät 4 und/oder der Datenbank 6 ausgebildet, insbesondere mittels der Kommunikationsschnittstelle 5A.

Die Datenbank 6 ist vorzugsweise mit dem Akku 2, dem Gerät 3, dem Kommunikationsgerät 4 und/oder der Datenverarbeitungseinrichtung 5 datentechnisch verbunden bzw. verbindbar. Hierzu weist die Datenbank 6 vorzugsweise eine Kommunikationsschnittstelle 6A auf. Insbesondere ist die Datenbank 6 zur (Daten-)Kommunikation mit dem Akku 2, dem Gerät 3, dem Kommunikationsgerät 4 und/oder der Datenverarbeitungseinrichtung 5 ausgebildet, insbesondere mittels der Kommunikationsschnittstelle 6A.

Die datentechnischen Verbindungen bzw. Kommunikationsverbindungen zwischen dem Akku 2, dem Gerät 3, dem Kommunikationsgerät 4, der Datenverarbeitungseinrichtung 5 und der Datenbank 6 bzw. deren Kommunikationsschnittstellen 2A-6A sind in Fig. 1 insbesondere durch Pfeile angedeutet.

Es ist bevorzugt, dass der Akku 2 nur mit dem Gerät 3 kommuniziert, das Gerät 3 nur mit dem Akku 2 und dem Kommunikationsgerät 4 kommuniziert und das Kommunikationsgerät 4 nur mit dem Gerät 3 und der Datenverarbeitungseinrichtung 5 bzw. Datenbank 6 kommuniziert. Grundsätzlich ist jedoch eine direkte Kommunikation zwischen allen Komponenten des Systems 1 möglich. Beispielsweise ist es möglich, dass der Akku 2 nicht nur mit dem Gerät 3, sondern alternativ oder zusätzlich direkt mit dem Kommunikationsgerät 4 und/oder der Datenverarbeitungseinrichtung 5 bzw. Datenbank 6 kommuniziert.

Vorzugsweise erfolgt die (Daten-)Kommunikation zwischen dem Akku 2, Gerät 3, Kommunikationsgerät 4, der Datenverarbeitungseinrichtung 5 und/oder der Datenbank 6 (jeweils) drahtlos, beispielsweise über NFC, Bluetooth, WLAN, Funk, das Mobilfunknetz und/oder das Internet.

Das System 1 weist vorzugsweise eine Benutzerschnittstelle 7 auf. Insbesondere weist der Akku 2, das Gerät 3 und/oder das Kommunikationsgerät 4 (jeweils) eine Benutzerschnittstelle 7 auf, wobei diese in diesem Fall gemeinsam die Benutzerschnittstelle 7 des Systems 1 bilden.

Die Benutzerschnittstelle 7 ist insbesondere eine Einrichtung, über die, insbesondere von einem Benutzer des Akkus 2 bzw. Geräts 3, Einstellungen zu dem Akku 2 und/oder Gerät 3 vornehmbar sind, über die der Akku 2 und/oder das Gerät 3 steuerbar bzw. bedienbar sind und/oder über die Informationen zu dem Akku 2 und/oder dem Gerät 3 abrufbar sind. Insbesondere weist die Benutzerschnittstelle 7 eine mit dem Akku 2 bzw. Gerät 3 gekoppelte bzw. koppelbare App auf.

Es ist also besonders bevorzugt, dass das Kommunikationsgerät 4, insbesondere ein Smartphone oder dergleichen, eine App aufweist, über die Einstellungen zu dem Akku 2 und/oder Gerät 3 vornehmbar sind und Informationen zu dem Akku 2 und/oder dem Gerät 3 abrufbar sind, wobei die Benutzerschnittstelle 7 die App des Kommunikationsgeräts 4 aufweist. Zusätzlich zu der App kann die Benutzerschnittstelle 7 selbstverständlich weitere Einrichtungen, insbesondere Eingabeeinrichtungen wie Tasten oder Knöpfe und Ausgabeeinrichtungen wie Displays und/oder Lautsprecher, an dem Akku 2 und/oder Gerät 3 aufweisen.

Das System 1 bzw. der Akku 2 weist vorzugsweise eine mit dem Akku 2 betriebene Schutzelektronik 8 auf, die dazu ausgebildet ist, den Akku 2 gegen eine weitere Nutzung und/oder ein Laden zu sperren, wenn eine Mindestruhespannung UM des Akkus 2 erreicht oder unterschritten wird. Vorzugsweise wird die Schutzelektronik 8 mit dem Akku 2 betrieben bzw. wird die zum Betrieb der Schutzelektronik 8 benötigte Energie dem Akku 2 entnommen.

Die Mindestruhespannung UM des Akkus 2 ist insbesondere diejenige Ruhespannung U des Akkus 2, bei deren Erreichen oder Unterschreiten der Akku 2 nicht mehr geladen werden darf. Insbesondere kann ein Laden des Akkus 2 nach Erreichen oder Unterschreiten der Mindestruhespannung UM zu einer Beschädigung oder Zerstörung des Akkus 2 führen, insbesondere zu einem Akkubrand.

Das System 1 ist zur Durchführung des hierin beschriebenen Verfahrens zum Betreiben des Systems 1 ausgebildet. Wenn daher nachfolgend ein Verfahrensschritt beschrieben wird, so ist das System 1 bzw. die Komponente des Systems 1, die den Verfahrensschritt durchführt, zur Durchführung des Verfahrensschritts ausgebildet, auch wenn dies nicht explizit erwähnt ist.

Das erfindungsgemäße Verfahren ist vorzugsweise ein computerimplementiertes Verfahren.

Das System 1 ist vorzugsweise ein System zur Datenverarbeitung, welches Mittel zur Ausführung des hierin beschriebenen Verfahrens aufweist. Vorzugsweise weist das System 1 einen oder mehrere Prozessoren auf, der/die so konfiguriert ist/sind, dass er/sie das Verfahren ausführt/ausführen.

Ferner betrifft die vorliegende Erfindung vorzugsweise ein Computerprogrammprodukt, umfassend Befehle, die bei der Ausführung des Programms durch einen Computer diesen veranlassen, das hierin beschriebene Verfahren auszuführen.

Schließlich betrifft die vorliegende Erfindung ebenfalls ein computerlesbares Speichermedium, umfassend das Computerprogrammprodukt und/oder Befehle, die bei der Ausführung durch einen Computer diesen veranlassen, das hierin beschriebene Verfahren auszuführen.

Bei dem erfindungsgemäßen Verfahren wird unter Berücksichtigung einer Selbstentladung des Systems 1 automatisch eine Lagerungszeit T des Akkus 2 bestimmt, insbesondere berechnet.

Die Lagerungszeit T ist dabei die (maximale) Zeit, die bei Lagerung bzw. Nichtbenutzung des Akkus 2 bis zum Erreichen oder Unterschreiten eines vorgegebenen Grenzwerts G1, G2, G3 einer Ruhespannung U des Akkus 2 verbleibt.

Die "Ruhespannung" U des Akkus 2, auch als Leerlaufspannung bezeichnet, ist insbesondere die Spannung an einer Ausgangsseite des Akkus 2, wenn kein Verbraucher an den Akku 2 angeschlossen ist bzw. mit dem Akku 2 kein (externer) Verbraucher, insbesondere das Gerät 3, betrieben wird. Die Schutzelektronik 8 wird hierbei nicht als an den Akku 2 angeschlossener Verbraucher betrachtet. Die Ruhespannung U des Akkus 2 ist insbesondere die Spannung an der Ausgangsseite des Akkus 2, wenn der Akku 2 deaktiviert ist.

Eine "Lagerung" des Akkus 2 ist insbesondere ein Zustand des Akkus 2, in dem der Akku 2 nicht verwendet wird und/oder das Gerät 3 nicht mit dem Akku 2 betrieben wird. Bei Lagerung des Akkus 2 kann der Akku 2 in das Gerät 3 eingesetzt sein oder aus dem Gerät 3 entnommen sein. Insbesondere liegt eine Lagerung des Akkus 2 vor, wenn das Gerät 3 nicht mit dem Akku 2 betrieben wird und/oder der Akku 2 bzw. das Gerät 3 deaktiviert ist, insbesondere ausgeschaltet ist oder sich in einem Standby-Modus befindet.

Eine "Selbstentladung" des Systems 1 ist insbesondere eine Entladung des Systems 1 bzw. des Akkus 2, die bei Lagerung des Akkus 2 erfolgt und/oder die erfolgt, ohne dass das Gerät 3 mit dem Akku 2 betrieben wird und/oder wenn das Gerät 3 und/oder der Akku 2 deaktiviert sind, insbesondere ausgeschaltet sind oder sich in einem Standby-Modus befinden.

Die Selbstentladung des Systems 1 bzw. Akkus 2 erfolgt vorzugsweise zumindest teilweise oder überwiegend durch den Betrieb der Schutzelektronik 8 bei Lagerung des Akkus 2. Alternativ oder zusätzlich kann eine Selbstentladung des Systems 1 bzw. Akkus 2 durch einen Ruhestromverbrauch I eines an den Akku 2 angeschlossenen Verbrauchers, insbesondere des Geräts 3, erfolgen. Die Selbstentladung des Systems 1 wird bei der Bestimmung der Lagerungszeit T vorzugsweise berücksichtigt.

Die Lagerungszeit T hängt insbesondere von dem vorgegebenen Grenzwert G1, G2, G3 der Ruhespannung U des Akkus 2 ab. Es gibt vorzugsweise mehrere Möglichkeiten zur Festlegung bzw. Definition dieses Grenzwertes G1, G2, G3. Insbesondere ist es auch möglich, dass mehrere Lagerungszeiten T berechnet bzw. bestimmt werden bzw. dass bezüglich mehrerer oder aller der nachfolgend erläuterten Grenzwerte G1, G2, G3 eine zugehörige Lagerungszeit T berechnet bzw. bestimmt wird.

Der Grenzwert G1, G2, G3 ist vorzugsweise ein (erster) Grenzwert G1, bei dessen Erreichen oder Unterschreiten ein Laden des Akkus 2 automatisch blockiert wird. Dieser (erste) Grenzwert G1 entspricht insbesondere der Mindestruhespannung UM des Akkus 2.

Alternativ oder zusätzlich ist der Grenzwert G1, G2, G3 ein (zweiter) Grenzwert G2, bei dessen Erreichen oder Unterschreiten eine Lagerung des Akkus 2 ohne ein (vorheriges) Laden des Akkus 2 nicht mehr möglich ist. Insbesondere ist dieser Grenzwert G1, G2, G3 so gewählt, dass innerhalb einer vorgegebenen Zeit, beispielsweise innerhalb einiger Minuten oder Stunden, die Mindestruhespannung UM des Akkus 2 erreicht oder unterschritten wird, sofern kein Laden des Akkus 2 erfolgt.

Alternativ oder zusätzlich ist der Grenzwert G1, G2, G3 ein (dritter) Grenzwert G3, bei dessen Erreichen oder Unterschreiten keine Nutzung des Akkus 2 ohne vorheriges Laden möglich ist. Dieser (dritte) Grenzwert G3 ist vorzugsweise so gewählt, dass noch eine weitere Lagerung des Akkus 2 für eine vorgegebene Zeit, beispielsweise für mehrere Stunden oder Tage, möglich ist, ohne dass die Mindestruhespannung UM erreicht oder unterschritten wird. Eine Nutzung des Akkus 2 ohne vorheriges Laden, insbesondere ein Betreiben des Geräts 3 mit dem Akku 2, würde jedoch dazu führen, dass die Mindestruhespannung UM nach kurzer Zeit, beispielsweise nach weniger als fünf Minuten, zwei Minuten oder einer Minute, erreicht oder unterschritten würde.

Vorzugsweise ist der (dritte) Grenzwert G3 größer als der (zweite) Grenzwert G2 und/oder der (erste) Grenzwert G1. Der (zweite) Grenzwert G2 ist vorzugsweise größer als der (erste) Grenzwert G1 bzw. die Mindestruhespannung UM. Insbesondere gilt also die Beziehung G3>G2>G1=UM.

Alternativ oder zusätzlich können auch ein oder mehrere weitere Grenzwerte festgelegt sein. Beispielsweise kann ein Grenzwert festgelegt sein, bei dem der Akku 2 noch eine vorgegebene entnehmbare Ladungsmenge Q aufweist, wobei die Ladungsmenge Q so gewählt sein kann, dass noch eine bestimmte Nutzung des Akkus 2 bzw. Geräts 3 möglich ist, bevor einer oder mehrere der Grenzwerte G1, G2, G3 erreicht werden. Insbesondere kann die zu diesem weiteren Grenzwert korrespondierende Ladungsmenge Q so bemessen sein, dass noch ein typischer bzw. durschnittlicher Benutzungsvorgang des Geräts 3 durchführbar ist (etwa die Reinigung einer bestimmten Fläche o. dgl.) und/oder das Gerät 3 noch für eine bestimmte Zeit betrieben werden kann, beispielsweise fünf oder zehn Minuten.

Die Bestimmung der Lagerungszeit T wird vorzugsweise automatisch durchgeführt, insbesondere mittels des Kommunikationsgeräts 4 und/oder der Datenverarbeitungseinrichtung 5. Insbesondere wird die Bestimmung der Lagerungszeit T durchgeführt, wenn, insbesondere nach einem Betrieb des Geräts 3 mit dem Akku 2, der Akku 2 und/oder das Gerät 3 automatisch oder manuell durch einen Nutzer deaktiviert wird.

Eine Deaktivierung in diesem Sinne ist insbesondere ein Ausschalten des Akkus 2 und/oder Geräts 3, ein Versetzen des Akkus 2 und/oder Geräts 3 in einen Standby-Modus und/oder ein Entnehmen des Akkus 2 aus dem Gerät 3.

Vorzugsweise erkennt/erkennen das System 1, der Akku 2 und/oder das Gerät 3 automatisch, wenn der Akku 2 und/oder das Gerät 3 deaktiviert wird bzw. werden soll und führt daraufhin die Bestimmung der Lagerungszeit T durch oder veranlasst die Bestimmung der Lagerungszeit **T,** bevorzugt bevor die Deaktivierung erfolgt bzw. abgeschlossen ist. Hierzu weist das System 1 bzw. der Akku 2 vorzugsweise ein Batteriemanagementsystem auf. Das Batteriemanagementsystem weist vorzugsweise die Schutzelektronik 8 auf.

Es ist möglich und bevorzugt, dass vor der Deaktivierung die Bestimmung der Lagerungszeit T noch nicht abgeschlossen ist. Beispielsweise können vor der Deaktivierung lediglich erforderliche, insbesondere akkuspezifische, Daten D zur Bestimmung der Lagerungszeit T abgerufen, ermittelt und/oder übermittelt werden, insbesondere von dem Akku 2 an das Gerät 3, das Kommunikationsgerät 4 und/oder die Datenverarbeitungseinrichtung 5 bzw. Datenbank 6. Die anschließende Bestimmung der Lagerungszeit T anhand dieser abgerufenen, ermittelten und/oder übermittelten Daten D kann dann vorzugsweise erfolgen, wenn der Akku 2 bzw. das Gerät 3 bereits deaktiviert wurde.

Bei der Bestimmung der Lagerungszeit T wird vorzugsweise eine dem Akku 2 entnehmbare Ladungsmenge Q verwendet bzw. berücksichtigt. Insbesondere ist die Ladungsmenge Q diejenige Ladungsmenge Q, die bis zum Erreichen des vorgegebenen Grenzwerts G1, G2, G3 verbleibt.

Die dem Akku 2 entnehmbare Ladungsmenge Q ist insbesondere diejenige Ladungsmenge Q, die dem Akku 2 zum Zeitpunkt der Bestimmung der Lagerungszeit T bzw. zum Zeitpunkt des Abrufs der für die Bestimmung der Lagerungszeit T erforderlichen Daten D bzw. zum Zeitpunkt der Deaktivierung noch entnehmbar ist. In diesem Sinne ist die dem Akku 2 entnehmbare Ladungsmenge Q bei der Bestimmung der Lagerungszeit T insbesondere jeweils eine aktuelle Ladungsmenge Q des Akkus 2 bzw. eine aktuell in dem Akku 2 enthaltene bzw. gespeicherte Ladungsmenge Q.

Vorzugsweise wird die dem Akku 2 entnehmbare Ladungsmenge Q anhand eines Ladungsmengenindikators QI bestimmt.

Insbesondere ist die Ladungsmenge Q nicht direkt an dem Akku 2 messbar und/oder ist der Ladungsmengenindikator QI eine direkt an dem Akku 2 messbare und/oder zum Zeitpunkt der Bestimmung der Lagerungszeit T direkt vorliegende oder abrufbare Größe, auf deren Basis die dem Akku 2 entnehmbare Ladungsmenge Q bestimmt werden kann.

Grundsätzlich ist es jedoch auch möglich, dass bei bzw. zur Bestimmung der Lagerungszeit T die dem Akku 2 entnehmbare Ladungsmenge Q direkt abgerufen wird bzw. kein Ladungsmengenindikator QI (als Zwischenschritt bzw. Zwischengröße) zur Bestimmung der Ladungsmenge Q verwendet wird. Beispielsweise kann die Ladungsmenge Q direkt aus dem Datenspeicher 2B des Akkus 2 abrufbar sein, insbesondere wenn die Ladungsmenge Q kontinuierlich, regelmäßig und/oder automatisch bestimmt und in dem Datenspeicher 2B gespeichert wird, insbesondere mittels eines Batteriemanagementsystems des Akkus 2.

Der Ladungsmengenindikator QI ist insbesondere ein Ladezustand SC des Akkus 2 und/oder die Ruhespannung U des Akkus 2.

Der Ladezustand SC (englisch: State Of Charge, kurz SOC) ist vorzugsweise das Verhältnis zwischen der dem Akku 2 (zu einem bestimmten Zeitpunkt) entnehmbaren Ladungsmenge Q und der dem Akku 2 maximal entnehmbaren Ladungsmenge Q und wird insbesondere in % ausgedrückt.

Die dem Akku 2 maximal entnehmbare Ladungsmenge Q ist die Ladungsmenge Q, die dem Akku 2 entnehmbar ist, wenn er vollgeladen ist.

Somit ist der Ladezustand SC eines vollgeladenen Akkus 2 SC = 100 %. Entsprechend bedeutet ein Ladezustand SC von SC = 60 %, dass die dem Akku 2 entnehmbare Ladungsmenge Q 60 % der Ladungsmenge Q beträgt, die dem Akku 2 entnehmbar wäre, wenn er vollgeladen wäre.

Anstelle des Ladezustands SC kann auch die Ruhespannung U des Akkus 2 als Ladungsmengenindikator QI verwendet werden. Insbesondere ist die Ruhespannung U äquivalent zu dem Ladezustand SC bzw. kann die Ruhespannung U in den Ladezustand SC umgerechnet werden.

Vorzugsweise wird der Ladungsmengenindikator QI, insbesondere automatisch, ermittelt, wenn bzw. bevor der Akku 2 und/oder das Gerät 3 deaktiviert werden.

Die Ermittlung des Ladungsmengenindikators QI erfolgt insbesondere durch eine Messung, insbesondere des Ladezustands SC und/oder der Ruhespannung U des Akkus 2.

Es ist jedoch auch möglich, dass der aktuelle Ladezustand SC und/oder die aktuelle Ruhespannung U des Akkus 2 fortlaufend, regelmäßig und/oder kontinuierlich gemessen oder überwacht wird/werden und/oder jeweils automatisch gespeichert ist/sind, insbesondere in dem Datenspeicher 2B des Akkus 2, so dass eine Ermittlung des Ladungsmengenindikators QI einfach durch Abruf des gespeicherten Ladezustands SC und/oder der gespeicherten Ruhespannung U erfolgt.

Die dem Akku 2 entnehmbare Ladungsmenge Q ist vorzugsweise von dem Ladungsmengenindikator QI, insbesondere der Ruhespannung U, abhängig bzw. als Funktion des Ladungsmengenindikators QI, insbesondere der Ruhespannung U, darstellbar.

Bei der Bestimmung der Lagerungszeit T wird vorzugsweise eine Ladungsmengenfunktion FQ verwendet, die verschiedenen Werten des Ladungsmengenindikators QI jeweils eine dem Akku 2 entnehmbare Ladungsmenge Q zuordnet. Die Ladungsmengenfunktion FQ beschreibt insbesondere die dem Akku 2 entnehmbare Ladungsmenge Q als Funktion des Ladungsmengenindikators QI (FQ=Q(QI)). Insbesondere beschreibt die Ladungsmengenfunktion FQ also die dem Akku 2 entnehmbare Ladungsmenge Q als Funktion des Ladezustands SC (FQ=Q(SC)) und/oder der Ruhespannung U (FQ=Q(U)).

Die Ladungsmengenfunktion FQ ist insbesondere eine diskrete Funktion, also eine Funktion, die diskreten bzw. abzählbar vielen Werten des Ladungsmengenindikators QI jeweils eine Ladungsmenge Q zuordnet. Die Ladungsmengenfunktion FQ liegt vorzugsweise in Form einer Tabelle bzw. Look Up Table vor. Hier sind jedoch auch andere Lösungen möglich, beispielsweise dass die Ladungsmengenfunktion FQ in Form eines Diagramms, einer Funktionsgleichung oder einer sonstigen Zuordnungsvorschrift vorliegt.

Der Akku 2 weist vorzugsweise einen Alterungszustand SH (englisch: State of Health, kurz SOH) auf, der insbesondere bei der Bestimmung der Lagerungszeit T verwendet bzw. berücksichtigt wird.

Es ist bekannt, dass Akkus mit fortschreitender Nutzung und/oder Lebensdauer "altern", das heißt, dass die Leistungsfähigkeit eines Akkus 2 im Laufe der Zeit abnimmt. Die Alterung eines Akkus 2 äußert sich insbesondere durch einen Kapazitäts- und/oder Spannungsverlust des Akkus 2 und/oder eine Zunahme des Innenwiderstands des Akkus 2. Vorzugsweise wird der Alterungszustand SH als Verhältnis zwischen einer Restkapazität und einer Nennkapazität des Akkus 2 ausgedrückt, insbesondere in %.

Die Restkapazität des Akkus 2 ist insbesondere die dem vollgeladenen Akku 2 entnehmbare Ladungsmenge Q. Insbesondere kann sich die Restkapazität von einer Nennkapazität des Akkus 2 unterscheiden.

Die Nennkapazität des Akkus 2 ist insbesondere die dem Akku 2 maximal entnehmbare Ladungsmenge Q ohne Verluste durch Alterung des Akkus 2. Insbesondere ist einem bis zur Nennkapazität vollgeladenen Akku 2 mehr Ladungsmenge Q entnehmbar als einem bis zur Restkapazität vollgeladenen Akku 2. Wenn die Restkapazität beispielsweise 80 % der Nennkapazität aufweist, so lassen sich dem Akku 2, selbst wenn er vollgeladen wird, nur noch maximal 80 % der Ladungsmenge Q entnehmen, die einem bis zur Nennkapazität vollgeladenen Akku 2 entnehmbar wären.

Vorzugsweise wird der Alterungszustand SH, insbesondere automatisch, ermittelt, wenn bzw. bevor der Akku 2 und/oder das Gerät 3 deaktiviert werden.

Die Ermittlung des Alterungszustands SH kann beispielsweise durch eine Messung oder Bestimmung der Restkapazität und/oder eine Messung des Innenwiderstands des Akkus 2, insbesondere in Kombination mit einem Abgleich der gemessenen Restkapazität bzw. des gemessenen Innenwiderstands mit einer Nennkapazität bzw. einem Nennwiderstand erfolgen. Alternativ oder zusätzlich kann eine Ermittlung des Alterungszustands SH anhand einer Alterungsfunktion oder dergleichen berechnet werden, insbesondere auf Basis von gemessenen Eigenschaften des Akkus 2. Ferner ist es auch möglich, dass der aktuelle Alterungszustand SH des Akkus 2 separat bestimmt und/oder fortlaufend, regelmäßig und/oder kontinuierlich gemessen oder überwacht wird und/oder jeweils automatisch gespeichert ist, insbesondere in dem Datenspeicher 2B des Akkus 2, so dass eine Ermittlung des Alterungszustands SH einfach durch Abruf des gespeicherten Alterungszustands SH erfolgt.

Die einem Wert des Ladungsmengenindikators QI, insbesondere der Ruhespannung U, zugeordnete dem Akku 2 entnehmbare Ladungsmenge Q bzw. die zu einem Wert des Ladungsmengenindikators QI, insbesondere der Ruhespannung U, korrespondierende dem Akku 2 entnehmbare Ladungsmenge Q ist insbesondere von dem Alterungszustand SH des Akkus 2 abhängig. Dementsprechend ist verschiedenen Alterungszuständen SH vorzugsweise jeweils eine Ladungsmengenfunktion FQ zugeordnet. Bei der Bestimmung der Lagerungszeit T wird vorzugsweise die dem jeweiligen Alterungszustand SH des Akkus 2 zugeordnete Ladungsmengenfunktion FQ verwendet.

Mit anderen Worten ist die dem Akku 2 entnehmbare Ladungsmenge Q insbesondere abhängig von dem Ladungsmengenindikator QI und dem Alterungszustand SH. Die vorgenannten verschiedenen Ladungsmengenfunktionen FQ können daher auch in einer mehrdimensionalen Ladungsmengenfunktion FQ zusammengefasst bzw. als mehrdimensionale Ladungsmengenfunktion FQ aufgefasst werden bzw. vorliegen, die verschiedenen Wertepaaren von Ladungsmengenindikator QI und Alterungszustand SH jeweils eine Ladungsmenge Q zuordnet. In diesem Fall beschreibt die Ladungsmengenfunktion FQ die dem Akku 2 entnehmbare Ladungsmenge Q als Funktion des Ladungsmengenindikators QI und des Alterungszustands SH (FQ=Q(QI, SH)). Auch durch eine solche mehrdimensionale Ladungsmengenfunktion FQ sind verschiedene Ladungsmengenfunktionen FQ gebildet, die jeweils einem Alterungszustand SH zugeordnet sind.

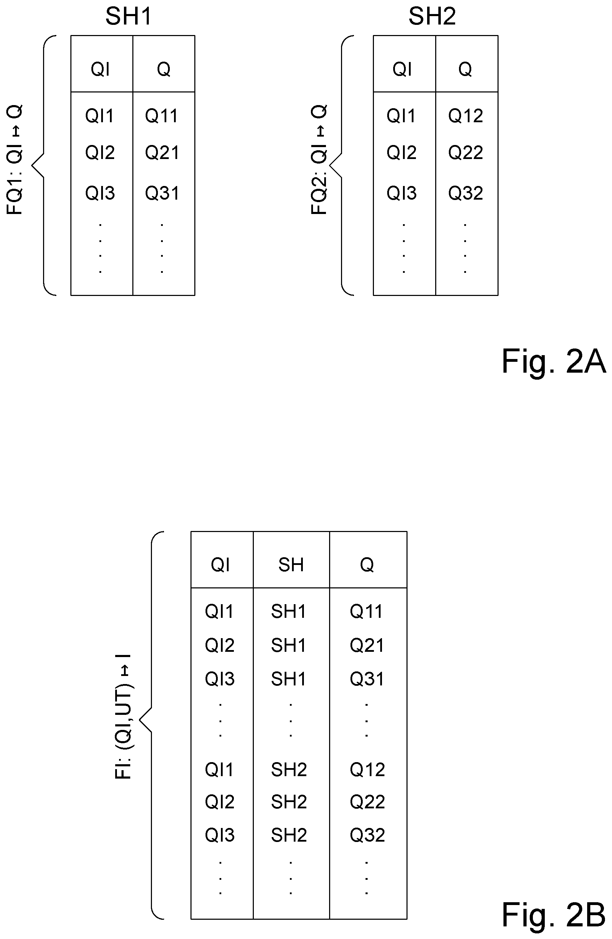

Die Fig. 2A zeigt schematisch und beispielhaft zwei verschiedene Ladungsmengenfunktionen FQ1, FQ2 in Tabellenform.

Auf der linken Seite in Fig. 2A ist eine erste Ladungsmengenfunktion FQ1 gezeigt, die verschiedenen Werten QI1, QI2, QI3 usw. des Ladungsmengenindikators QI jeweils eine Ladungsmenge Q11, Q21, Q31 usw. zuordnet. Die Zuordnung erfolgt insbesondere unter Berücksichtigung eines ersten Alterungszustands SH1. Dem ersten Alterungszustand SH1 ist daher insbesondere die erste Ladungsmengenfunktion FQ1 zugeordnet.

Auf der rechten Seite in Fig. 2A ist eine zweite Ladungsmengenfunktion FQ2 gezeigt. Diese Ladungsmengenfunktion FQ2 ordnet den gleichen Werten QI1, QI2, QI3 usw. des Ladungsmengenindikators QI die Ladungsmengen Q12, Q22, Q32 usw. zu. Die Zuordnung erfolgt insbesondere unter Berücksichtigung eines zweiten Alterungszustands SH2. Dem zweiten Alterungszustand SH2 ist daher insbesondere die zweite Ladungsmengenfunktion FQ2 zugeordnet.

Insbesondere können sich die einem Wert des Ladungsmengenindikators QI durch verschiedene Ladungsmengenfunktionen FQ1, FQ2 zugeordnete Ladungsmengen Q unterscheiden. Beispielsweise können die Ladungsmengen Q11 und Q12, die Ladungsmengen Q21 und Q22 und/oder die Ladungsmengen Q31 und Q32 unterschiedlich sein.

Die Fig. 2B zeigt beispielhaft eine Darstellung verschiedener Ladungsmengenfunktionen FQ als mehrdimensionale Funktion in Tabellenform. Die Abhängigkeit der dem Akku 2 entnehmbaren Ladungsmenge Q von dem Ladungsmengenindikator QI und dem Alterungszustand SH ist dabei in einer einzelnen Tabelle dargestellt, statt in mehreren Tabellen wie in Fig. 2A. Die Darstellung in Fig. 2B ist äquivalent zur Darstellung in Fig. 2A und kann ebenfalls als Darstellung mehrerer Ladungsmengenfunktionen FQ aufgefasst werden, die jeweils einem Alterungszustand SH zugeordnet sind, wie es beispielhaft in Fig. 2A gezeigt ist.

Mit anderen Worten können Ladungsmengenfunktionen FQ, die verschiedenen Alterungszuständen SH zugeordnet sind, in Form von mehreren Funktionen bzw. Tabellen, wie beispielhaft in Fig. 2A gezeigt, oder in Form einer einzelnen mehrdimensionalen Funktion bzw. Tabelle, wie beispielhaft in Fig. 2B gezeigt, vorliegen. In beiden Fällen liegen dann im Sinne der vorliegenden Erfindung mehrere Ladungsmengenfunktionen FQ vor, die jeweils einem Alterungszustand SH zugeordnet sind.

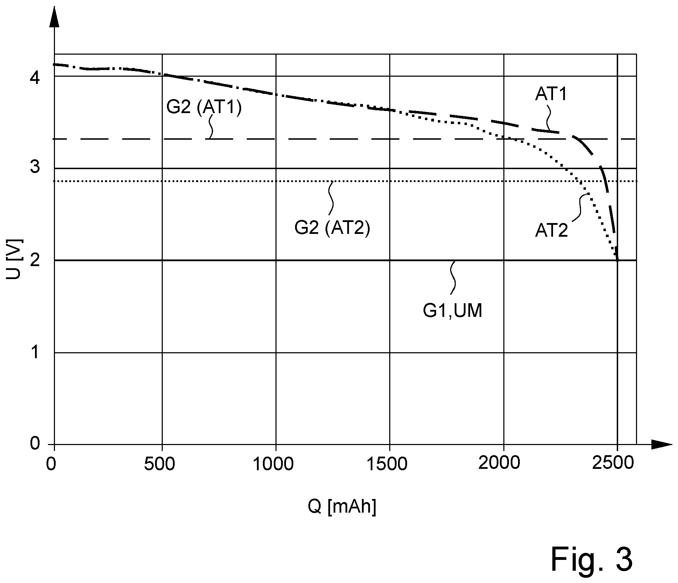

Fig. 3 zeigt beispielhaft für zwei verschiedene Akkus 2 bzw. zwei Akkus 2 verschiedenen Akkutyps AT1, AT2 eine Darstellung der Ruhespannung U des jeweiligen Ackus 2 in Abhängigkeit von der dem jeweiligen Akku 2 entnommenen Ladungsmenge Q. Dabei zeigt die gestrichelte Kurve die Ruhespannung des Akkus 2 vom Akkutyp AT1 und die gepunktete Kurve zeigt die Ruhespannung des Akkus 2 vom Akkutyp AT2. Es ist erkennbar, dass grundsätzlich mit zunehmender einem Akku 2 entnommener Ladungsmenge Q die Ruhespannung U abnimmt. Eingezeichnet ist außerdem die Mindestruhespannung UM, bei deren Erreichen oder Unterschreiten der Akku 2 nicht mehr geladen werden darf, da das Laden zu einer Beschädigung oder Zerstörung des Akkus 2 führen könnte. In Fig. 3 beträgt die Mindestruhespannung UM = 2V.

Aus Fig. 3 ist ersichtlich, dass der Verlauf der Ruhespannung U in Abhängigkeit von der entnommenen Ladungsmenge Q für verschiedene Akkus 2 unterschiedlich sein kann. Außerdem ist die Steigung nicht konstant, sondern typischerweise fällt die Ruhespannung U umso stärker ab, je mehr Ladungsmenge Q einem Akku 2 entnommen wird.

Des Weiteren kann bei verschiedenen Akkus 2 die dem jeweiligen Akku 2 bei einer gegebenen Ruhespannung U bis zum Erreichen der Mindestruhespannung UM noch entnehmbare Ladungsmenge Q unterschiedlich sein. Beispielhaft ist in Fig. 3 für die gestrichelte und gepunktete Kurve bzw. die Akkus 2 des Akkutyps AT1 und AT2 jeweils der zuvor erläuterte (zweite) Grenzwert G2 eingezeichnet. Im Darstellungsbeispiel ist der Grenzwert G2 so festgelegt, dass noch 175 mAh als entnehmbare Ladungsmenge Q verbleiben. Aufgrund der unterschiedlichen Verläufe der Ruhespannung U hat der Grenzwert G2 für den Akku 2 des Akkutyps AT1 einen anderen Wert als für den Akku 2 des Akkutyps AT2. Im Darstellungsbeispiel hat der Grenzwert G2 für den Akkutyp AT1 etwa den Wert G2 = 3,3 V und für den Akkutyp AT2 etwa den Wert G2 = 2,9 V.

Die Fig. 3 kann auch als graphische Darstellung der Ladungsmengenfunktionen FQ verschiedener Akkus 2 aufgefasst werden, wobei die Ruhespannung U als bevorzugtes Beispiel des Ladungsmengenindikators QI gegen die Ladungsmenge Q aufgetragen wurde, mit anderen Worten also jeder (entnommenen) Ladungsmenge Q eine Ruhespannung zugeordnet ist/wurde, und auf der x-Achse anstelle der dem Akku 2 noch entnehmbaren Ladungsmenge Q die bereits entnommene Ladungsmenge Q aufgetragen ist.

Der Akku 2 weist vorzugsweise einen Ruhestromverbrauch I auf. Insbesondere führt der Ruhestromverbrauch I zu einer Selbstentladung des Akkus 2. Der Ruhestromverbrauch I ist vorzugsweise zumindest teilweise oder überwiegend der Stromverbrauch der Schutzelektronik 8.

Vorzugsweise ist der Ruhestromverbrauch I des Akkus 2 ein Stromverbrauch des Akkus 2 bei Lagerung bzw. ohne dass ein Verbraucher, insbesondere das Gerät 3, an den Akku 2 angeschlossen ist bzw. mit dem Akku 2 betrieben wird. Mit anderen Worten ist der Ruhestromverbrauch I vorzugsweise der Stromverbrauch des Akkus 2, wenn der Akku 2 deaktiviert ist.

Der Ruhestromverbrauch I des Akkus 2 ist vorzugsweise von dem Ladungsmengenindikator QI, insbesondere der Ruhespannung U, abhängig bzw. als Funktion des Ladungsmengenindikators QI, insbesondere der Ruhespannung U, darstellbar.

Vorzugsweise wird bei der Bestimmung der Lagerungszeit T eine Ruhestromfunktion FI verwendet, die verschiedenen Werten des Ladungsmengenindikators QI, insbesondere der Ruhespannung U, jeweils einen Ruhestromverbrauch I zuordnet. Die Ruhestromfunktion FI beschreibt insbesondere den Ruhestromverbrauch I des Ackus 2 als Funktion des Ladungsmengenindikators QI (FI=I(QI)). Insbesondere beschreibt die Ruhestromfunktion FI also den Ruhestromverbrauch I des Akkus als Funktion des Ladezustands SC (FI=I(SC)) und/oder der Ruhespannung U (FI=I(U)).

Die Ruhestromfunktion FI ist insbesondere eine diskrete Funktion, also eine Funktion, die diskreten bzw. abzählbar vielen Werten des Ladungsmengenindikators QI jeweils einen Ruhestromverbrauch I zuordnet. Die Ruhestromfunktion FI liegt vorzugsweise in Form einer Tabelle bzw. Look Up Table vor. Hier sind jedoch auch andere Lösungen möglich, beispielsweise dass die Ruhestromfunktion FI in Form eines Diagramms, einer Funktionsgleichung oder einer sonstigen Zuordnungsvorschrift vorliegt.

Ferner wurde bei der vorliegenden Erfindung erkannt, dass der Ruhestromverbrauch I des Akkus 2 auch von der Umgebungstemperatur UT des Akkus 2 abhängig ist bzw. sein kann. Bei der Bestimmung der Lagerungszeit T wird daher vorzugsweise eine Ruhestromfunktion FI verwendet, die verschiedenen Umgebungstemperaturen UT jeweils einen Ruhestromverbrauch I zuordnet.

Insbesondere ist der einem Wert des Ladungsmengenindikators QI, insbesondere der Ruhespannung U, zugeordnete Ruhestromverbrauch I bzw. der zu einem Wert des Ladungsmengenindikators QI, insbesondere der Ruhespannung U, korrespondierende Ruhestromverbrauch I von der Umgebungstemperatur UT des Akkus 2 abhängig. Dementsprechend ist verschiedenen Umgebungstemperaturen UT vorzugsweise jeweils eine Ruhestromfunktion FI zugeordnet. Bei der Bestimmung der Lagerungszeit T wird vorzugsweise die der jeweiligen Umgebungstemperatur UT des Ackus 2 zugeordnete Ruhestromfunktion FI verwendet.

Mit anderen Worten ist der Ruhestromverbrauch I des Akkus 2 insbesondere abhängig von dem Ladungsmengenindikator QI und der Umgebungstemperatur UT. Die vorgenannten verschiedenen Ruhestromfunktionen FI können daher auch in einer mehrdimensionalen Ruhestromfunktion FI zusammengefasst bzw. als mehrdimensionale Ruhestromfunktion FI aufgefasst werden bzw. vorliegen, die verschiedenen Wertepaaren von Ladungsmengenindikator QI und Umgebungstemperatur UT jeweils einen Ruhestromverbrauch I zuordnet. In diesem Fall beschreibt die Ruhestromfunktion FI den Ruhestromverbrauch I als Funktion des Ladungsmengenindikators QI und der Umgebungstemperatur UT (FI=I(QI, UT)). Auch durch eine solche mehrdimensionale Ruhestromfunktion FI sind verschiedene Ruhestromfunktionen FI gebildet, die jeweils einer Umgebungstemperatur UT zugeordnet sind.

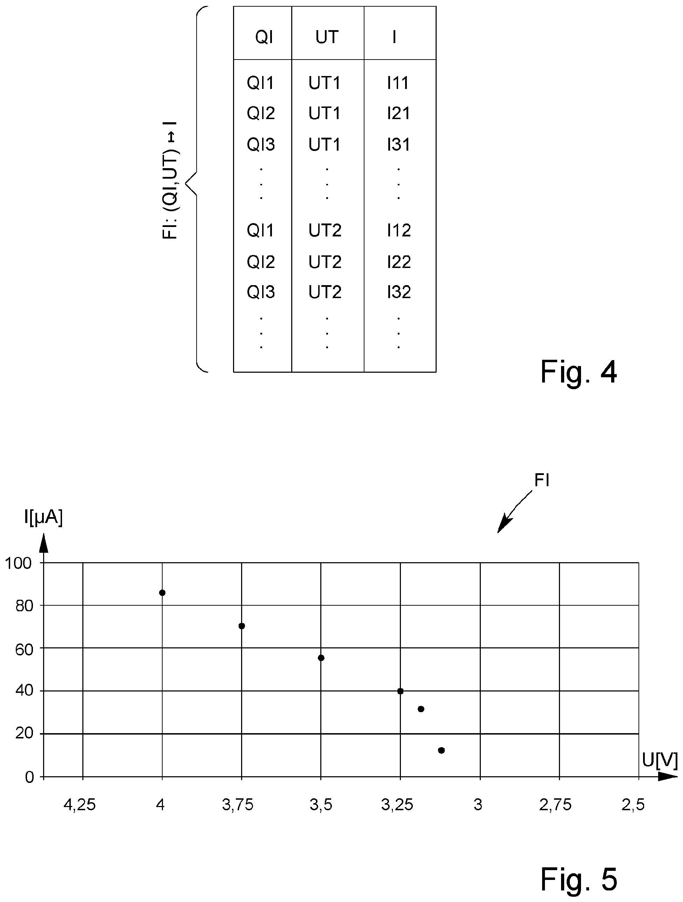

Die Fig. 4 zeigt beispielhaft eine Ruhestromfunktion FI in Tabellenform, wobei die Ruhestromfunktion FI als mehrdimensionale Funktion dargestellt ist bzw. die Abhängigkeit des Ruhestromverbrauchs I von dem Ladungsmengenindikator QI und der Umgebungstemperatur UT in einer einzelnen Tabelle dargestellt ist. Die Darstellung der Ruhstromfunktion FI in Fig. 4 ist analog zur Darstellung der Ladungsmengenfunktion FQ in Fig. 2B. Entsprechend wäre auch bei der Ruhestromfunktion FI eine Darstellung analog zu Fig. 2A möglich. Die Erläuterungen bezüglich der unterschiedlichen Möglichkeiten der Darstellung der Ladungsmengenfunktionen FQ, die verschiedenen Alterungszuständen SH zugeordnet sind, gelten entsprechend analog für Ruhestromfunktionen FI, die verschiedenen Umgebungstemperaturen UT zugeordnet sind. Insbesondere liegen im Sinne der vorliegenden Erfindung auch bei einer mehrdimensionalen Ruhestromfunktion FI, wie beispielhaft in Fig. 4 dargestellt, mehrere Ruhestromfunktionen FI vor, die jeweils einer Umgebungstemperatur UT zugeordnet sind.

Die Fig. 5 zeigt beispielhaft in einem Diagramm den Ruhestromverbrauch I eines Akkus 2 in Abhängigkeit von der Ruhespannung U. Die Ruhestromfunktion FI kann auch in Form eines Diagramms wie in Fig. 5 gezeigt vorliegen. Insbesondere stellt auch das Diagramm aus Fig. 5 eine Ruhestromfunktion FI dar, wobei der Ladungsmengenindikator QI durch die Ruhespannung U gebildet ist.

Vorzugsweise hängt der Ruhestromverbrauch I nur mittelbar von dem Alterungszustand SH des Akkus 2 ab. Insbesondere geht der Alterungszustand SH daher nicht explizit bzw. direkt in die Ruhestromfunktion FI ein, sondern nur mittelbar über die Abhängigkeit der Ruhespannung U von dem Alterungszustand SH, die in der Ladungsmengenfunktion FQ berücksichtigt ist.

Die Lagerungszeit T wird insbesondere als Quotient der Ladungsmenge Q und des Ruhestromverbrauchs I berechnet (T = Q/I). Ausgehend von der Ruhestromfunktion FI wird insbesondere ein mittlerer Ruhestromverbrauch I, vorzugsweise unter Berücksichtigung der Umgebungstemperatur UT, des Ladungsmengenindikators QI bzw. der Ruhespannung U und/oder des Alterungszustands SH des Akkus 2 ermittelt bzw. berechnet. Der mittlere Ruhestromverbrauch I kann beispielsweise ein Mittelwert und/oder Durchschnittswert der Ruhestromfunktion FI sein.

Die Berechnung bzw. Bestimmung des mittleren Ruhestromverbrauchs I erfolgt vorzugsweise numerisch, iterativ und/oder durch Integration und/oder Mittelung der Ruhestromfunktion FI.

Die Umgebungstemperatur UT wird vorzugsweise gemessen. Vorzugsweise weist das System 1, insbesondere der Akku 2 und/oder das Gerät 3, einen oder mehrere Temperatursensoren 9 zur Messung der Umgebungstemperatur UT des Akkus 2 auf.

Es ist jedoch auch möglich, dass die Umgebungstemperatur UT als Parameter durch einen Nutzer vorgegeben wird. Dies kann beispielsweise durch Eingabe der Umgebungstemperatur UT in dem Akku 2, dem Gerät 3 und/oder in dem Kommunikationsgerät 4 erfolgen, insbesondere über die Benutzerschnittstelle 7 und/oder eine App. In diesem Fall stellt die Umgebungstemperatur UT vorzugsweise eine überwiegende, übliche und/oder mittlere Umgebungstemperatur UT des Akkus 2, insbesondere bei Lagerung, dar.

Vorzugsweise wird ein Akkutyp AT des Akkus 2 bei der Bestimmung der Lagerungszeit T berücksichtigt bzw. verwendet wird. Der Akkutyp AT umfasst insbesondere einen Zelltyp des Akkus 2, also eine Information darüber, welche Art und/oder Anzahl von Zellen der Akku 2 aufweist. Unterschiedliche Akkus 2 bzw. Zellen können sich beispielsweise in ihrer Kapazität bzw. maximal entnehmbaren Ladungsmenge Q, Ruhespannung U, Verschaltung (beispielsweise Parallelschaltung oder Serienschaltung) und/oder Zellchemie bzw. Zelltyp (beispielsweise Lithium-Eisen-Phosphat (LFP), Lithium-Nickel-Mangan-Cobaltoxid (NMC), Lithium-Nickel-Cobalt-AluminiumOxid (NCA) oder Lithium-Cobalt(III)-Oxid (LCO)) unterscheiden.

Es ist bevorzugt, dass bei der Bestimmung der Lagerungszeit T eine eineindeutige Identifikationsnummer SN, insbesondere eine Seriennummer, des Akkus 2 verwendet bzw. berücksichtigt wird. Dies ermöglicht insbesondere den Abruf von akkuspezifischen Daten D, so dass die Lagerungszeit T spezifisch für den jeweiligen Akku 2 bestimmt werden kann. Dies ist einer genauen Bestimmung der Lagerungszeit T zuträglich.

Die eineindeutige Identifikationsnummer SN ermöglicht vorzugsweise eine eindeutige Identifikation des jeweiligen Akkus 2 und insbesondere eine Unterscheidung des Akkus 2 von anderen Akkus 2 des gleichen Akkutyps AT.

Insbesondere werden (akkuspezifische) Bestimmungsgrößen, die zur Bestimmung der Lagerungszeit T verwendet bzw. benötigt werden, anhand der eineindeutigen Identifikationsnummer SN des Akkus 2 ermittelt oder abgerufen, insbesondere wenn bzw. bevor der Akku 2 und/oder das Gerät 3 deaktiviert werden.

Die Bestimmung der Lagerungszeit T erfolgt vorzugsweise anhand von akkuspezifischen Daten D. Insbesondere wird also nicht nur der Akkutyp AT des Akkus 2 berücksichtigt, sondern spezifische Daten D des Akkus 2, beispielsweise der Ladungsmengenindikator QI, der insbesondere durch den Ladezustand SC und/oder die Ruhespannung des Akkus 2 gebildet ist, und/oder der Alterungszustand SH des Akkus 2.

Akkuspezifische Daten D sind insbesondere solche Daten D, die den Akku 2 von anderen baugleichen Akkus 2 bzw. anderen Akkus 2 des gleichen Akkutyps AT unterscheiden. Insbesondere repräsentieren die akkuspezifischen Daten D einen aktuellen Zustand des Akkus 2. Vorzugsweise stellen der Ladungsmengenindikator QI (insbesondere also der Ladezustand SC und/oder die Ruhespannung U), der Alterungszustand SH, der Akkutyp AT, die eineindeutige Identifikationsnummer SN, die Art der Schutzelektronik 8 und/oder die Umgebungstemperatur UT des Akkus 2 ackuspezifische Daten D dar.

Der Ladungsmengenindikator QI, der Alterungszustand SH, der Akkutyp AT, die eineindeutige Identifikationsnummer SN und/oder die Umgebungstemperatur UT ist/sind vorzugsweise in dem Datenspeicher 2B des Akkus 2 gespeichert und/oder von dem Akku 2 abrufbar. Grundsätzlich ist es jedoch auch möglich, dass die akkuspezifischen Daten D bzw. der Ladungsmengenindikator QI, die eineindeutige Identifikationsnummer SN, der Akkutyp AT und/oder der Alterungszustand SH alternativ oder zusätzlich in dem Gerät 3, dem Kommunikationsgerät 4 und/oder der Datenbank 6 gespeichert sind bzw. werden.

Vorzugsweise übermittelt der Akku 2 den Ladungsmengenindikator QI, den Alterungszustand SH, den Akkutyp AT, die eineindeutige Identifikationsnummer SN und/oder die Umgebungstemperatur UT an das Gerät 3.

Vorzugsweise übermittelt das Gerät 3 die von dem Akku 2 empfangenen Daten D weiter an das Kommunikationsgerät 4. Das Kommunikationsgerät 4 übermittelt vorzugsweise den Ladungsmengenindikator QI, den Alterungszustand SH, den Akkutyp AT, die eineindeutige Identifikationsnummer SN und/oder die Umgebungstemperatur UT an die Datenverarbeitungseinrichtung 5 bzw. Datenbank 6. Besonders bevorzugt ist es, dass das Kommunikationsgerät 4 lediglich den Akkutyp AT und/oder die Identifikationsnummer SN an die Datenverarbeitungseinrichtung 5 bzw. die Datenbank 6 übermittelt und diese daraufhin dem jeweiligen Akku 2 zugeordnete Bestimmungsgrößen, anhand derer die Lagerungszeit T bestimmt werden kann, an das Kommunikationsgerät 4 übermittelt. Dies ist insbesondere in Fig. 1 durch entsprechende Pfeile symbolisiert. Die Übermittlung der Daten und/oder Bestimmungsgrößen erfolgt insbesondere mittels der Kommunikationsschnittstellen 2A-6A.

Bestimmungsgrößen sind insbesondere Rechengrößen, Rechenvorschriften, Tabellen, (mathematische) Funktionen oder dergleichen, anhand derer die Bestimmung der Lagerungszeit T ermöglicht wird bzw. erfolgt, insbesondere auf Basis der akkuspezifischen Daten. Insbesondere stellen die Ladungsmengenfunktion FQ und die Ruhestromfunktion FI jeweils eine Bestimmungsgröße zur Bestimmung der Lagerungszeit T dar.

Die Bestimmung der Lagerungszeit T des Akkus 2 erfolgt vorzugsweise mittels des Kommunikationsgeräts 4, insbesondere auf Basis der akkuspezifischen Daten D und/oder der Bestimmungsgrößen. Besonders bevorzugt ist es dabei, wie beschrieben, dass die akkuspezifischen Daten D, insbesondere Ladungsmengenindikator QI, Alterungszustand SH, Akkutyp AT, eineindeutige Identifikationsnummer SN und/oder Umgebungstemperatur UT, von dem Akku 2 an das Gerät 3 und von dort weiter an das Kommunikationsgerät 4 übermittelt werden, wobei das Kommunikationsgerät 4 den Akkutyp AT und/oder die Identifikationsnummer SN an die Datenverarbeitungseinrichtung 5 bzw. Datenbank 6 übermittelt und von dieser im Gegenzug benötigte Bestimmungsgrößen zur Bestimmung der Lagerungszeit T auf Basis der akkuspezifischen Daten D erhält und die Bestimmung der Lagerungszeit T mittels des Kommunikationsgeräts 4 auf Basis der akkuspezifischen Daten D und der Bestimmungsgrößen erfolgt.

Grundsätzlich sind hier jedoch auch andere Lösungen möglich. Insbesondere können die Bestimmungsgrößen, die in dem beschriebenen besonders bevorzugten Ausführungsbeispiel in der Datenbank 6 gespeichert sind und von der Datenverarbeitungseinrichtung 5 bzw. Datenbank 6 an das Kommunikationsgerät 4 übermittelt werden, auch auf dem Akku 2, dem Gerät 3 und/oder dem Kommunikationsgerät 4 gespeichert sein.

Ebenso können die akkuspezifischen Daten D, die in dem besonders bevorzugten Ausführungsbeispiel in dem Datenspeicher 2B des Akkus 2 gespeichert sind, alternativ oder zusätzlich in dem Gerät 3, dem Kommunikationsgerät 4 und/oder der Datenbank 6 gespeichert sein.

Schließlich ist es auch möglich, dass die Bestimmung der Lagerungszeit T nicht oder nicht vollständig mittels des Kommunikationsgeräts 4, sondern alternativ oder zusätzlich mittels des Akkus 2, des Geräts 3 und/oder der Datenverarbeitungseinrichtung 5 erfolgt. Dabei können auch einzelne Schritte der Bestimmung der Lagerungszeit T auf verschiedenen Komponenten des Systems 1 durchgeführt werden.

In den akkuspezifischen Daten D und/oder der Ruhestromfunktion FI können auch spezielle Funktionalitäten des Akkus 2 bzw. Geräts 3 berücksichtigt sein, die zu einem erhöhten Ruhestromverbrauch I beitragen, beispielsweise ein zyklisches Aufwachen des Akkus 2 und/oder Geräts 3 oder sonstige Funktionalitäten.

Die Ladungsmengenfunktion FQ und/oder die Ruhestromfunktion FI ist/sind vorzugsweise für den Akkutyp AT des Akkus 2 spezifisch.

Die vorzugsweise empirisch ermittelte Ladungsmengenfunktion FQ und/oder die vorzugsweise empirisch ermittelte Ruhestromfunktion FI ist/sind vorzugsweise in der Datenverarbeitungseinrichtung 5 bzw. der Datenbank 6 gespeichert. Insbesondere umfasst die Datenverarbeitungseinrichtung 5 bzw. Datenbank 6 mehrere Ladungsmengenfunktionen FQ, insbesondere für verschiedene Akkutypen AT und/oder Alterungszustände SH, und/oder mehrere Ruhestromfunktionen FI, insbesondere für verschiedene Akkutypen AT und/oder Umgebungstemperaturen UT.

Die Ladungsmengenfunktion(en) FQ und/oder Ruhestromfunktion(en) FI können jedoch auch alternativ oder zusätzlich auf dem Akku 2 bzw. in dessen Datenspeicher 2B, in dem Gerät 3 und/oder in dem Kommunikationsgerät 4 gespeichert sein.

Nach der Bestimmung der Lagerungszeit T wird die bestimmte Lagerungszeit T vorzugsweise gespeichert und/oder ausgegeben, insbesondere über die Benutzerschnittstelle 7 und/oder das Kommunikationsgerät 4. Besonders bevorzugt weist die Benutzerschnittstelle 7 bzw. das Kommunikationsgerät 4 eine App auf, über die eine Ausgabe der bestimmten Lagerungszeit T erfolgt. Dies kann beispielsweise über eine Push-Benachrichtigung oder eine Anzeige der bestimmten Lagerungszeit T in bzw. bei Aufruf der App erfolgen. Alternativ oder zusätzlich kann auch ein akustisches und/oder vibratorisches Signal ausgegeben werden. Grundsätzlich ist es jedoch auch möglich, dass die bestimmte Lagerungszeit T mittels des Akkus 2 und/oder des Geräts 3 ausgegeben wird. Hierzu weist die Benutzerschnittstelle 7 bzw. der Akku 2 und/oder das Gerät 3 vorzugsweise eine insbesondere optische und/oder akustische Ausgabeeinrichtung wie ein Display und/oder einen Lautsprecher oder dergleichen auf.

Vorzugsweise wird vor bzw. bei Erreichen der bestimmten Lagerungszeit T eine Mitteilung, insbesondere Warnung, ausgegeben. Insbesondere wird die Mitteilung bzw. Warnung vor bzw. bei Erreichen oder Unterschreiten des Grenzwerts G1, G2, G3 ausgegeben und/oder wenn nur noch eine beispielsweise durch einen Nutzer vorgegebene Mindestlagerzeit bzw. Mindestlademenge verbleibt.

Beispielsweise kann vorgesehen sein, dass die Mindestlagerzeit einen oder mehrere Tage beträgt und/oder die Mindestlademenge der für einen Anwendungsvorgang, wie einen Reinigungsvorgang, (durchschnittlich) erforderlichen Lademenge entspricht. Die Mitteilung wird in diesen Fällen dann ausgegeben, wenn von der bestimmten Lagerungszeit nur noch die vorgegebene Mindestlagerzeit bzw. nur noch die Mindestlagemenge für einen Anwendungsvorgang verbleibt.

Zusätzlich oder alternativ kann vorgesehen sein, dass automatisch erfasst und/oder durch einen Nutzer vorgegeben wird, wie lang der Akku 2 (durchschnittlich) nach der Verwendung, beispielsweise zwischen zwei Anwendungsvorgängen, gelagert wird bzw. lagerbar sein muss. Der Nutzer kann dann über die Mitteilung darüber informiert werden, ob die bestimmte Lagerungszeit T (voraussichtlich) ausreicht oder vor Lagerung den Akku 2 geladen werden sollte.

Die Mitteilung kann beispielsweise Informationen über den derzeitigen Ladungsmengenindikator QI (insbesondere Ladezustand SC und/oder Ruhespannung U), die bestimmte Lagerungszeit T, ein erforderliches Laden des Akkus 2 und/oder ein (bevorstehendes oder erfolgtes) Blockieren eines Ladens des Akkus 2 enthalten. Insbesondere können für die unterschiedlichen Grenzwerte G1, G2, G3 unterschiedliche Mitteilungen ausgegeben werden. Alternativ oder zusätzlich kann die Mitteilung Hinweise bzw. Aufforderungen zu erforderlichen Handlungen, wie beispielsweise ein erforderliches Laden des Akkus 2 und/oder Hinweise bzw. Empfehlungen für eine verbesserte oder optimierte Nutzung des Akkus 2 bzw. Geräts 3, beispielsweise zu einem optimierten Laden, enthalten.

Die Ausgabe der Mitteilung erfolgt insbesondere über die Benutzerschnittstelle 7 und/oder das Kommunikationsgerät 4, insbesondere die voranstehend beschriebene App des Kommunikationsgeräts 4. Grundsätzlich kann die Mitteilung jedoch auch von dem System 1 bzw. einer der Komponenten des System 1 nach außen ausgegeben werden, beispielsweise als E-Mail oder Kalendereintrag an eine E-Mailadresse des Nutzers oder dergleichen.

Es kann auch vorgesehen sein, dass vor bzw. bei Ablauf der bestimmten Lagerungszeit T der Akku 2 automatisch geladen wird, insbesondere wenn der Akku 2 während der Lagerung an ein Ladegerät angeschlossen ist.

Bei einer besonders bevorzugten Verfahrensvariante ist vorgesehen, dass bei Erreichen eines vordefinierten Alterungszustands SH und/oder bei Unterschreiten einer vordefinierten Mindestlagerzeit den Nutzer automatisch aufgefordert wird, den Akku 2 für die Lagerung (dauerhaft) an ein Ladegerät anzuschließen ist, sodass der Akku 2 während der Lagerung automatisch geladen werden kann.

Insbesondere wird die Bestimmung der Lagerungszeit T nach einer Benutzung des Akkus 2 bzw. Geräts 3, einer Entladung des Akkus 2 und/oder einem Laden des Akkus 2 (erneut) bestimmt. Vorzugsweise erfolgt dann wiederum eine Ausgabe einer oder mehrerer entsprechender Mitteilungen, wie voranstehend beschrieben. So kann der Nutzer stets über die aktuelle Lagerungszeit T informiert bleiben.

Einzelne Aspekte, Merkmale und Verfahrensschritte der vorliegenden Erfindung können unabhängig voneinander, aber auch in beliebiger Kombination oder Reihenfolge realisiert werden.

### Bezugszeichenliste:

- 1: System
- 2: Akku
- 2A: Kommunikationsschnittstelle
- 2B: Datenspeicher
- 3: Gerät
- 3A: Kommunikationsschnittstelle
- 4: Kommunikationsgerät
- 4A: Kommunikationsschnittstelle
- 5: Datenverarbeitungseinrichtung
- 5A: Kommunikationsschnittstelle
- 6: Datenbank
- 6A: Kommunikationsschnittstelle
- 7: Benutzerschnittstelle
- 8: Schutzelektronik
- 9: Temperatursensor

- AT: Akkutyp
- D: Daten
- FI: Ruhestromfunktion
- FQ: Ladungsmengenfunktion
- G1: Grenzwert
- G2: Grenzwert
- G3: Grenzwert
- I: Ruhestromverbrauch
- Q: Ladungsmenge
- QI: Ladungsmengenindikator
- SC: Ladezustand
- SH: Alterungszustand
- SN: Identifikationsnummer
- T: Lagerungszeit
- U: Ruhespannung
- UM: Mindestruhespannung
- UT: Umgebungstemperatur

## Patentansprüche

1. Verfahren zum Betreiben eines Systems (1) mit einem Akku (2), insbesondere Lithium-Ionen-Akku,
wobei unter Berücksichtigung einer Selbstentladung des Systems (1) automatisch eine Lagerungszeit (T) des Akkus (2) bestimmt wird, wobei die Lagerungszeit (T) die bei Lagerung des Akkus (2) bis zum Erreichen oder Unterschreiten eines vorgegebenen Grenzwerts (G1, G2, G3) einer Ruhespannung (U) des Akkus (2) verbleibende Zeit ist,
wobei der Akku (2) eine dem Akku (2) entnehmbare Ladungsmenge (Q) aufweist, die bei der Bestimmung der Lagerungszeit (T) verwendet wird,
wobei die dem Akku (2) entnehmbare Ladungsmenge (Q) von einem Ladungsmengenindikator (QI), insbesondere der Ruhespannung (U), des Akkus (2) abhängig ist und bei der Bestimmung der Lagerungszeit (T) eine Ladungsmengenfunktion (FQ) verwendet wird, die verschiedenen Werten des Ladungsmengenindikators (QI), insbesondere der Ruhespannung (U), jeweils eine dem Akku (2) entnehmbare Ladungsmenge (Q) zuordnet,
**dadurch gekennzeichnet,**
**dass** die zu einem Wert des Ladungsmengenindikators (QI) korrespondierende Ladungsmenge (Q) von einem Alterungszustand (SH) des Akkus (2) abhängig ist und verschiedenen Alterungszuständen (SH) jeweils eine Ladungsmengenfunktion (FQ) zugeordnet ist, wobei bei der Bestimmung der Lagerungszeit (T) die dem jeweiligen Alterungszustand (SH) des Akkus (2) zugeordnete Ladungsmengenfunktion (FQ) verwendet wird.

2. Verfahren nach Anspruch 1, **dadurch gekennzeichnet, dass** der Akku (2) einen Ruhestromverbrauch (I) aufweist, der bei der Bestimmung der Lagerungszeit (T) berücksichtigt wird, insbesondere wobei der Ruhestromverbrauch (I) zumindest teilweise durch die Selbstentladung des Akkus (2) bedingt ist.

3. Verfahren nach Anspruch 2, **dadurch gekennzeichnet, dass** der Ruhestromverbrauch (I) des Akkus (2) von einem Ladungsmengenindikator (QI), insbesondere der Ruhespannung (U), des Akkus (2) abhängig ist und bei der Bestimmung der Lagerungszeit (T) eine Ruhestromfunktion (FI) verwendet wird, die verschiedenen Werten des Ladungsmengenindikators (QI), insbesondere der Ruhespannung (U), jeweils einen Ruhestromverbrauch (I) zuordnet.

4. Verfahren nach Anspruch 3, **dadurch gekennzeichnet, dass** der einem Wert des Ladungsmengenindikators (QI) zugeordnete Ruhestromverbrauch (I) von der Umgebungstemperatur (UT) des Akkus (2) abhängig ist und verschiedenen Umgebungstemperaturen (UT) jeweils eine Ruhestromfunktion (FI) zugeordnet ist, wobei bei der Bestimmung der Lagerungszeit (T) die der jeweiligen Umgebungstemperatur (SH) des Akkus (2) zugeordnete Ruhestromfunktion (FI) verwendet wird.

5. Verfahren nach Anspruch 3 oder 4, **dadurch gekennzeichnet, dass** anhand der dem Akku (2) entnehmbaren Ladungsmenge (Q), der Ladungsmengenfunktion (FQ) und der Ruhestromfunktion (FI) die Lagerungszeit (T) iterativ, numerisch, durch **In**tegration und/oder durch Mittelung, insbesondere der Ruhestromfunktion (I), bestimmt, insbesondere berechnet, wird.

6. Verfahren nach einem der voranstehenden Ansprüche, **dadurch gekennzeichnet, dass** bei der Bestimmung der Lagerungszeit (T), insbesondere zur Bestimmung einer dem Akku (2) entnehmbaren Ladungsmenge (Q) des Akkus (2) und/oder zur Auswahl einer dem Akku (2) zugeordneten Ladungsmengenfunktion (FQ) und/oder Ruhestromfunktion (I), ein Ladungsmengenindikator (QI), insbesondere ein Ladungszustand (SC) und/oder eine Ruhespannung (U), ein Alterungszustand (SH), ein Akkutyp (AT) und/oder eine eineindeutige Identifikationsnummer (SN) des Akkus (2) abgerufen und/oder berücksichtigt wird/werden.

7. Verfahren nach einem der voranstehenden Ansprüche, **dadurch gekennzeichnet, dass** das System (1) eine mit dem Akku (2) betriebene Schutzelektronik (8) aufweist, die dazu ausgebildet ist, den Akku (2) gegen eine weitere Nutzung und/oder ein Laden zu sperren, wenn eine vorgegebene Mindestruhespannung (UM) des Ackus (2) erreicht oder unterschritten wird, wobei die Selbstentladung zumindest teilweise durch den Betrieb der Schutzelektronik (8) bei Lagerung des Akkus (2) erfolgt.

8. Verfahren nach einem der voranstehenden Ansprüche, **dadurch gekennzeichnet, dass** das System (1) ein an den Akku (2) angeschlossenes Gerät (3) mit einem Ruhestromverbrauch (I) aufweist, wobei durch den Ruhestromverbrauch (I) des Geräts (3) eine Selbstentladung des Akkus (2) bei Lagerung erfolgt und die Selbstentladung durch den Ruhestromverbrauch (I) des Geräts (3) bei der Bestimmung der Lagerungszeit (T) des Akkus (2) berücksichtigt wird.

9. Verfahren nach einem der voranstehenden Ansprüche, **dadurch gekennzeichnet, dass** eine Bestimmung der Lagerungszeit (T) automatisch erfolgt, wenn das System (1) bzw. der Akku (2) deaktiviert wird.

10. Verfahren nach einem der voranstehenden Ansprüche, **dadurch gekennzeichnet, dass** nach Bestimmung der Lagerungszeit (T) und/oder vor bzw. bei Erreichen oder Unterschreiten des Grenzwerts (G1, G2, G3) eine Mitteilung über den Ladezustand (SC), die bestimmte Lagerungszeit (T), ein erforderliches Laden des Akkus (2) und/oder ein Blockieren eines Ladens des Akkus (2) ausgegeben wird, insbesondere über eine Benutzerschnittstelle (7) und/oder ein Kommunikationsgerät (4) des Systems (1).

11. Verfahren nach einem der voranstehenden Ansprüche, **dadurch gekennzeichnet, dass** der vorgegebene Grenzwert (G1, G2, G3) einer der folgenden Grenzwerte (G1, G2, G3) ist und/oder dass bezüglich mehrerer oder aller der folgenden Grenzwerte (G1, G2, G3) die jeweilige Lagerungszeit (T) bestimmt wird:
a) Grenzwert (G1), bei dessen Erreichen oder Unterschreiten ein Laden des Akkus (2) automatisch blockiert wird;
b) Grenzwert (G2), bei dessen Erreichen oder Unterschreiten eine Lagerung des Akkus (2) ohne Laden des Akkus (2) - insbesondere innerhalb einer vorgegebenen Zeit - nicht mehr möglich ist;
c) Grenzwert (G3), bei dessen Erreichen oder Unterschreiten keine Nutzung des Ackus (2) ohne vorheriges Laden möglich ist.

12. System (1) mit einem Akku (2), insbesondere wobei der Akku (2) zum Betreiben eines Haushaltsgeräts ausgebildet ist,
vorzugsweise wobei das System (1) zusätzlich zu dem Akku (2) ein mit dem Akku (2) betreibbares und datentechnisch verbundenes bzw. verbindbares Gerät (3), insbesondere Haushaltsgerät, ein insbesondere mit dem Akku (2) und/oder dem Gerät (3) datentechnisch verbundenes bzw. verbindbares Kommunikationsgerät (4), und/oder eine insbesondere mit dem Kommunikationsgerät (4), dem Gerät (3)
und/oder dem Akku (2) datentechnisch verbundene bzw. verbindbare Datenbank (6) aufweist,
**dadurch gekennzeichnet,**
**dass** das System (1) zum Durchführen eines Verfahrens nach einem der voranstehenden Ansprüche ausgebildet ist.

## Claims

1. Method for operating a system (1) having an accumulator (2), in particular a lithium-ion accumulator,
wherein a storage time (T) of the accumulator (2) is determined automatically taking into account a self-discharge of the system (1), wherein the storage time (T) is the time remaining when the accumulator (2) is stored until a predefined limit value (G1, G2, G3) of an open-circuit voltage (U) of the accumulator (2) is reached or undershot,
wherein the accumulator (2) has an charge quantity (Q) which can be drawn from the accumulator (2) and which is used in the determination of the storage time (T),
wherein the charge quantity (Q) which can be drawn from the accumulator (2) is dependent on a charge quantity indicator (QI), in particular the open-circuit voltage (U), of the accumulator (2), and a charge quantity function (FQ) is used in the determination of the storage time (T), which charge quantity function (FQ) in each case assigns a charge quantity (Q) which can be drawn from the accumulator (2) to different values of the charge quantity indicator (QI), in particular the open-circuit voltage (U),
**characterized**
**in that** the charge quantity (Q) which corresponds to a value of the charge quantity indicator (QI) is dependent on state of health (SH) of the accumulator (2), and a charge quantity function (FQ) is in each case assigned to different states of health (SH), wherein the charge quantity function (FQ) which is assigned to the respective state of health (SH) of the accumulator (2) is used in the determination of the storage time (T).

2. Method according to claim 1, **characterized in that** the accumulator (2) has an open-circuit current consumption (I) which is taken into account in the determination of the storage time (T), in particular wherein the open-circuit current consumption (I) is at least partially caused by the self-discharge of the accumulator (2).

3. Method according to claim 2, **characterized in that** the open-circuit current consumption (I) of the accumulator (2) is dependent on a charge quantity indicator (QI), in particular the open-circuit voltage (U), of the accumulator (2), and an open-circuit current function (FI) which in each case assigns an open-circuit current consumption (I) to different values of the charge quantity indicator (QI), in particular the open-circuit voltage (U), is used in the determination of the storage time (T).

4. Method according to claim 3, **characterized in that** the open-circuit current consumption (I) which is assigned to a value of the charge quantity indicator (QI) is dependent on the ambient temperature (UT) of the accumulator (2), and an open-circuit current function (FI) is in each case assigned to different ambient temperatures (UT), wherein the open-circuit current function (FI) which is assigned to the respective ambient temperature (SH) of the accumulator (2) is used in the determination of the storage time (T).

5. Method according to claim 3 or 4, **characterized in that** the storage time (T) is determined, in particular calculated, iteratively, numerically, by integration and/or by averaging, in particular the open-circuit current function (I), on the basis of the charge quantity (Q) which can be drawn from the accumulator (2), the charge quantity function (FQ) and the open-circuit current function (FI).

6. Method according to one of the preceding claims, **characterized in that** a charge quantity indicator (QI), in particular a state of charge (SC) and/or an open-circuit voltage (U), a state of health (SH), an accumulator type (AT) and/or a unique identification number (SN) of the accumulator (2) is/are retrieved and/or taken into account in the determination of the storage time (T), in particular for the determination of a charge quantity (Q) which can be drawn from the accumulator (2) and/or for the selection of a charge quantity function (FQ) and/or open-circuit current function (I) which is assigned to the accumulator (2).

7. Method according to one of the preceding claims, **characterized in that** the system (1) has protective electronics (8) which are operated with the accumulator (2) and which are designed to block the accumulator (2) against further use and/or charging when a predefined minimum open-circuit voltage (UM) of the accumulator (2) is reached or undershot, wherein the self-discharge takes place at least partially by the operation of the protective electronics (8) when the accumulator (2) is stored.

8. Method according to one of the preceding claims, **characterized in that** the system (1) has a device (3) which is connected to the accumulator (2) and has an open-circuit current consumption (I), wherein self-discharge of the accumulator (2) takes place during storage by the open-circuit current consumption (I) of the device (3) and the self-discharge is taken into account by the open-circuit current consumption (I) of the device (3) in the determination of the storage time (T) of the accumulator (2).

9. Method according to one of the preceding claims, **characterized in that** a determination of the storage time (T) takes place automatically when the system (1) or the accumulator (2) is deactivated.

10. Method according to one of the preceding claims, **characterized in that** after determination of the storage time (T) and/or before or when the limit value (G1, G2, G3) is reached or undershot, a notification about the state of charge (SC), the determined storage time (T), a required charging of the accumulator (2) and/or a blocking of a charging of the accumulator (2) is output, in particular via a user interface (7) and/or a communication device (4) of the system (1).

11. Method according to one of the preceding claims, **characterized in that** the predefined limit value (G1, G2, G3) is one of the following limit values (G1, G2, G3) and/or **in that** the respective storage time (T) is determined with respect to a plurality of or all of the following limit values (G1, G2, G3):
a) limit value (G1) at which a charging of the accumulator (2) is automatically blocked when it is reached or undershot;
b) limit value (G2) at which a storage of the accumulator (2) without charging the accumulator (2), in particular within a predefined time, is no longer possible when it is reached or undershot;
c) limit value (G3) at which no use of the accumulator (2) without prior charging is possible when it is reached or undershot.

12. System (1) having an accumulator (2), in particular wherein the accumulator (2) is designed for operating a domestic appliance,
preferably wherein the system (1) has, in addition to the accumulator (2), a device (3), in particular a domestic appliance, which can be operated with the accumulator (2) and is connected or can be connected with the accumulator (2) in terms of data, a communication device (4), which is or can be connected in terms of data to the accumulator (2) and/or the device (3), and/or a database (6), which is or can be in particular connected in terms of data to the communication device (4), the device (3) and/or the accumulator (2),
**characterized in that**
the system (1) is designed for carrying out a method according to one of the preceding claims.

## Revendications

1. Procédé de fonctionnement d'un système (1) comprenant un accumulateur (2), en particulier un accumulateur lithium-ion,
dans lequel un temps de stockage (T) de l'accumulateur (2) est déterminé automatiquement en tenant compte d'une autodécharge du système (1), le temps de stockage (T) étant le temps restant pendant le stockage de l'accumulateur (2) jusqu'à ce qu'une valeur limite (G1, G2, G3) prédéfinie d'une tension de repos (U) de l'accumulateur (2) soit atteinte ou n'ait pas été atteinte,
dans lequel l'accumulateur (2) présente une quantité de charge (Q) pouvant être prélevée de l'accumulateur (2), qui est utilisée lors de la détermination du temps de stockage (T),
dans lequel la quantité de charge (Q) pouvant être prélevée de l'accumulateur (2) dépend d'un indicateur de quantité de charge (QI), en particulier de la tension de repos (U), de l'accumulateur (2) et, lors de la détermination du temps de stockage (T), une fonction de quantité de charge (FQ) est utilisée, qui associe à différentes valeurs de l'indicateur de quantité de charge (QI), en particulier de la tension de repos (U), à chaque fois une quantité de charge (Q) pouvant être prélevée de l'accumulateur (2),
**caractérisé en ce que**
la quantité de charge (Q) correspondant à une valeur de l'indicateur de quantité de charge (QI) dépend d'un état de vieillissement (SH) de l'accumulateur (2) et une fonction de quantité de charge (FQ) est à chaque fois associée à différents états de vieillissement (SH), la fonction de quantité de charge (FQ) associée à l'état de vieillissement (SH) respectif de l'accumulateur (2) étant utilisée lors de la détermination du temps de stockage (T).

2. Procédé selon la revendication 1, **caractérisé en ce que** l'accumulateur (2) présente une consommation de courant de repos (I) qui est prise en compte lors de la détermination du temps de stockage (T), la consommation de courant de repos (I) étant en particulier au moins en partie due à l'autodécharge de l'accumulateur (2).

3. Procédé selon la revendication 2, **caractérisé en ce que** la consommation de courant de repos (I) de l'accumulateur (2) dépend d'un indicateur de quantité de charge (QI), en particulier de la tension de repos (U), de l'accumulateur (2) et, lors de la détermination du temps de stockage (T), une fonction de courant de repos (FI) est utilisée, qui associe à différentes valeurs de l'indicateur de quantité de charge (QI), en particulier de la tension de repos (U), à chaque fois une consommation de courant de repos (I).

4. Procédé selon la revendication 3, **caractérisé en ce que** la consommation de courant de repos (I) associée à une valeur de l'indicateur de quantité de charge (QI) dépend de la température ambiante (UT) de l'accumulateur (2) et une fonction de courant de repos (FI) est à chaque fois associée à différentes températures ambiantes (UT), la fonction de courant de repos (FI) associée à la température ambiante (SH) respective de l'accumulateur (2) étant utilisée lors de la détermination du temps de stockage (T).

5. Procédé selon la revendication 3 ou 4, **caractérisé en ce que**, à l'aide de la quantité de charge (Q) pouvant être prélevée de l'accumulateur (2), de la fonction de quantité de charge (FQ) et de la fonction de courant de repos (FI), le temps de stockage (T) est déterminé, en particulier calculé, de manière itérative, numérique, par intégration et/ou par calcul de la moyenne, en particulier de la fonction de courant de repos (I).

6. Procédé selon l'une quelconque des revendications précédentes, **caractérisé en ce que**, lors de la détermination du temps de stockage (T), en particulier pour la détermination d'une quantité de charge (Q) pouvant être prélevée de l'accumulateur (2) et/ou pour la sélection d'une fonction de quantité de charge (FQ) et/ou d'une fonction de courant de repos (I) associée à l'accumulateur (2), un indicateur de quantité de charge (QI), en particulier un état de charge (SC) et/ou une tension de repos (U), un état de vieillissement (SH), un type d'accumulateur (AT) et/ou un numéro d'identification univoque (SN) de l'accumulateur (2) est/sont appelé(s) et/ou pris en compte.

7. Procédé selon l'une quelconque des revendications précédentes, **caractérisé en ce que** le système (1) présente une électronique de protection (8) fonctionnant avec l'accumulateur (2), qui est réalisée pour bloquer l'accumulateur (2) contre une utilisation ultérieure et/ou une charge lorsqu'une tension de repos minimale (UM) prédéfinie de l'accumulateur (2) est atteinte ou n'est pas atteinte, l'autodécharge étant effectuée au moins en partie par le fonctionnement de l'électronique de protection (8) pendant le stockage de l'accumulateur (2).

8. Procédé selon l'une quelconque des revendications précédentes, **caractérisé en ce que** le système (1) présente un appareil (3) raccordé à l'accumulateur (2) avec une consommation de courant de repos (I), une autodécharge de l'accumulateur (2) étant effectuée pendant le stockage par la consommation de courant de repos (I) de l'appareil (3) et l'autodécharge étant prise en compte par la consommation de courant de repos (I) de l'appareil (3) lors de la détermination du temps de stockage (T) de l'accumulateur (2).

9. Procédé selon l'une quelconque des revendications précédentes, **caractérisé en ce qu'**une détermination du temps de stockage (T) est effectuée automatiquement lorsque le système (1) ou l'accumulateur (2) est désactivé.

10. Procédé selon l'une quelconque des revendications précédentes, **caractérisé en ce qu'**après la détermination du temps de stockage (T) et/ou avant ou lorsque la valeur limite (G1, G2, G3) est atteinte ou n'a pas été atteinte, une notification concernant l'état de charge (SC), le temps de stockage (T) déterminé, une charge nécessaire de l'accumulateur (2) et/ou un blocage d'une charge de l'accumulateur (2) est émise, en particulier par le biais d'une interface utilisateur (7) et/ou d'un appareil de communication (4) du système (1).

11. Procédé selon l'une quelconque des revendications précédentes, **caractérisé en ce que** la valeur limite (G1, G2, G3) prédéfinie est l'une des valeurs limites (G1, G2, G3) suivantes et/ou **en ce que** le temps de stockage (T) respectif est déterminé par rapport à plusieurs ou à toutes les valeurs limites (G1, G2, G3) suivantes :
a) valeur limite (G1), lorsqu'une charge de l'accumulateur (2) est atteinte ou n'a pas été atteinte, est bloquée automatiquement ;
b) valeur limite (G2), lorsqu'un stockage de l'accumulateur (2) est atteint ou n'a pas été atteint, n'est plus possible sans charge de l'accumulateur (2), en particulier dans un temps prédéfini ;
c) valeur limite (G3), lorsqu'une utilisation de l'accumulateur (2) n'est pas possible sans charge préalable lorsqu'il est atteint ou n'a pas été atteint.

12. Système (1) comprenant un accumulateur (2), l'accumulateur (2) étant en particulier conçu pour faire fonctionner un appareil ménager,
le système (1) présentant de préférence, en plus de l'accumulateur (2), un appareil (3), en particulier un appareil ménager, pouvant fonctionner avec l'accumulateur (2) et relié ou pouvant être relié par une technique de données, un appareil de communication (4) relié ou pouvant être relié par une technique de données en particulier à l'accumulateur (2) et/ou à l'appareil (3), et/ou une base de données (6) reliée ou pouvant être reliée par une technique de données en particulier à l'appareil de communication (4), à l'appareil (3) et/ou à l'accumulateur (2),
**caractérisé en ce que**
le système (1) est conçu pour mettre en œuvre un procédé selon l'une quelconque des revendications précédentes.
